Europäisches Patentamt

European Patent Office

Office européen des brevets

(11) Veröffentlichungsnummer : **0 061 704
B1**

# (12) EUROPÄISCHE PATENTSCHRIFT

(45) Veröffentlichungstag der Patentschrift :
18.09.85

(21) Anmeldenummer : 82102423.9

(22) Anmeldetag : 24.03.82

(51) Int. Cl.⁴ : **G 01 R 27/18**

(54) Verfahren und Einrichtung zum Bestimmen der Gesamtableitungsimpedanz in einem ungeerdeten Wechselstromnetz.

(30) Priorität : 31.03.81 DE 3112952

(43) Veröffentlichungstag der Anmeldung :
06.10.82 Patentblatt 82/40

(45) Bekanntmachung des Hinweises auf die Patenterteilung : 18.09.85 Patentblatt 85/38

(84) Benannte Vertragsstaaten :
AT BE CH FR GB IT LI LU NL SE

(56) Entgegenhaltungen :
DE-A- 2 426 871
DE-A- 2 545 315
DE-A- 2 713 252
DE-B- 1 541 742
DE-B- 2 522 596
DE-B- 2 617 644
DE-B- 2 630 982
US-A- 4 200 836

(73) Patentinhaber : Dipl.-Ing. W. Bender GmbH & Co. KG
Londorfer Strasse 65
D-6310 Grünberg (DE)

(72) Erfinder : Eichmann, Arno, Dipl.-Ing.
Untere Hainbergstrasse 3
D-6301 Rabenau (DE)
Erfinder : Kaul, Karl-Hans, Dipl.-Ing.
Borneck 3
D-6324 Feldatal-Köddingen (DE)

(74) Vertreter : Schumacher, Bernd, Dipl.-Ing.
Am Schwaberg 13
D-6450 Hanau 6 (DE)

## Beschreibung

Die Erfindung bezieht sich auf ein Verfahren zum Bestimmen der Gesamtableitungsimpedanz in einem ungeerdeten Wechselstromnetz mittels eines in das Netz eingespeisten, insbesondere eingeprägten, über die Netzableitung fließenden Meßwechselstroms mit einer von der Frequenz der Netzwechselspannung abweichenden Frequenz und einer Auswertung der aus dem Meßwechselstrom resultierenden Meßwechselspannung zwischen Netz und Erde. Außerdem bezieht sich die Erfindung auf eine Einrichtung zum Durchführen des Verfahrens mit einer geerdeten sowie zumindest einpolig an das Wechselstromnetz angekoppelten Meßwechselstrom-Quelle und mit einer geerdeten sowie zumindest einpolig an das Wechselstromnetz angekoppelten Auswerteschaltung, die die aus dem über die Netzableitung fließenden Meßwechselstrom resultierende Meßechselspannung zwischen Netz und Erde erfaßt. Ein Verfahren bzw. eine Einrichtung mit diesen Merkmalen ist aus der DE-B2-1 541 742 bekannt.

In bekannter Weise stellt ein ideales, isoliertes bzw. ungeerdetes Wechselstromnetz einen optimalen Schutz für Menschen und Betriebsmittel dar. Das Berühren eines einzigen Netzleiters wäre an sich völlig ungefährlich. Da jedoch das reale Netz in unvermeidbarer Weise gemischt ohmsche-kapazitive Ableitimpedanzen der einzelnen Leiter nach Erde besitzt, kann bereits das Berühren nur eines einzigen Netzleiters gefährlich werden. Es kann nachgewiesen werden, daß der maximal mögliche Leiterberührungsstrom, der beim Berühren eines Netzleiters auftritt, gleich der maximalen Leiterspannung geteilt durch die Gesamtableitungsimpedanz des Netzes ist. Die Gesamtableitungsimpedanz stellt die Parallelschaltung der Ableitungsimpedanzen des gesamten Wechselstromnetzes das. Es ist demnach sinnvoll, die Gesamtableitungsimpedanz des ungeerdeten Wechselstromnetzes aus Sicherheitsgründen zu überwachen.

Die Gesamtableitungsimpedanz des Wechselstromnetzes kann gemäß dem Oberbegriff in bekannter Weise mit Hilfe eines zwischen Netz und Erde eingeprägten Meßwechselstroms bestimmt werden, der die Netzableitungen durchfließt und am Netz eine der Gesamtableitungsimpedanz proportionale Meßwechselspannung erzeugt. Während die Erfassung der Gesamtableitungsimpedanz im netzspannungsfreien Zustand des Wechselstromnetzes unkritisch ist, entstehen Problem dann, wenn die Überwachung der Gesamtableitungsimpedanz ständig, also auch im Netzspannungszustand des Wechselstromnetzes, erfolgen soll. In diesem Fall ist es möglich, einen Meßwechselstrom mit einer von der Netzfrequenz deutlich abweichenden Meßfrequenz zu benutzen, die beispielsweise ein Vielfaches der Netzfrequenz ausmacht. Die dabei ermittelte Gesamtableitungsimpedanz ist jedoch wegen ihrer Frequenzabhängigkeit in bezug auf die tatsächliche Gesamtableitungsimpedanz bei Netzfrequenz stark fehlerbehaftet.

Der vorliegenden Erfindung liegt daher die Aufgabe zugrunde, ein Verfahren und eine Einrichtung der im Oberbegriff genannten Art so auszubilden, daß sich die auf die Netzfrequenz bezogene Gesamtableitungsimpedanz des Wechselstromnetzes mit einfachen Maßnahmen sowie Mitteln möglichst genau bestimmen läßt.

Zur Lösung der gestellten Aufgabe zeichnet sich ein Verfahren der im Oberbegriff genannten Art erfindungsgemäß dadurch aus, daß dem Wechselstromnetz ein Meßwechselstrom mit einer der Netzfrequenz angenäherten Meßfrequenz phasendynamisch so überlagert wird, daß sich bei anliegender Netzwechselspannung durch ständiges Verändern der relativen Phasenlage zwischen den einander überlagerten Netz- und Meßwechselspannungen eine Schwebung ergibt, und daß bei amplitudenkonstantem Meßwechselstrom als Maß für die Gesamtableitungsimpedanz bei anliegender Netzwechselspannung die Spannungsamplitude einer der die Schwebung beidseitig begrenzenden Schwebungshüllkurven, sofern der an der Meßstelle anstehende Anteil der Meßwechselspannung maximal gleich demjenigen der Netzwechselspannung ist, oder die sich aus den maximalen und minimalen Spannungsamplituden der Schwebung ergebende mittlere Spannungsamplitude der Schwebung, sofern der an der Meßstelle anstehende Anteil der Meßwechselspannung minimal gleich demjenigen der Netzwechselspannung ist, und bei an der Meßstelle verschwindendem Anteil der Netzwechselspannung bzw. wegfallender Schwebung die Spannungsamplitude der Meßwechselspannung erfaßt wird, während bei amplitudenvariablem Meßwechselstrom für die Gesamtableitungsimpedanz der Quotient der jeweiligen Spannungsamplitude und der gleichzeitig auftretenden Meßwechselstrom-Amplitude erfaßt wird.

Das erfindungsgemäße Verfahren nutzt somit die Ausbildung einer Schwebung aus. Die Netzableitungen werden gleichzeitig von zwei Strömen durchflossen, die einerseits auf der Netzversorgung und andererseits auf dem Meßwechselstrom beruhen. Diese Wechselströme führen an den Netzableitungen zu entsprechenden Spannungsabfällen, die sich zu der genannten Schwebung addieren, wenn die Netz- und Meßfrequenzen ausreichend dicht beieinander liegen und eine nicht ganzahliges Teilerverhältnis haben. Es kann nachgewiesen werden, daß die Quelle mit dem geringeren Stromanteil die Quelle mit dem höheren Stromanteil überlagert. Das bedeutet, daß die die Schwebung beidseitig begrenzenden Schwebungshüllkurven eine Spannungsamplitude haben, die derjenigen der strombedingt kleineren Wechselspannung an der Netzableitung entspricht. Andererseits entspricht die zeitlich mittlere Spannungsamplitude der gesamten Schwebung der Spannungsamplitude der größeren Wechselspannung an der Netzableitung. Die Schwebungsfrequenz, das heißt die Frequenz der Amplitudenveränderung der Schwebung, entspricht dem Betrag der Differenz zwischen den Netz- und Meßfrequenzen. Während sich bei fehlendem Netzwechselspannungsanteil an der Meßstelle keine Schebung ausbildet, kann bei vorhandener Schwebung der Meßwechselspannungsanteil den Netzwechselspannungsanteil und umgekehrt überlagern. Das erfindungsgemäße Verfahren berücksichtigt diese verschiedenen Fälle und ermöglicht durch die der Netzfrequenz angenäherte Meßfrequenz ein weitgehend exaktes Erfassen der auf die Netzfrequenz bezogenen Gesamtableitungsimpedanz. Die Meßfrenquenz kann der Netzfrequenz praktisch beliebig angenähert werden, wenn eine für die Ausbildung der Schwebung ausreichende Phasendynamik der relativen Phasenlagen zwischen den überlagerten Wechselspannungen vorhanden ist. Das erfindungsgemäße Meßprinzip vermeidet demnach stark voneinander abweichende Netz- sowie Meßfrequenzen und damit verbundene Meßfehler sowie Sicherheitsgefährdungen. Die im Rahmen des erfindungsgemäßen Verfahrens zu bestimmenden Amplituden lassen sich mit einfachen Mitteln schnell und genau erfassen.

In weiterer Ausgestaltung des erfindungsgemäße Verfahrens wird vorgeschlagen, daß ein Meßwechselstrom mit einer variablen Meßfrequenz überlagert wird, die abwechselnd geringfügig größer und geringfügig kleiner als die Netzfrequenz ist, und daß eine Mittelung der aus den sich dadurch ergebenden Schwebungen bestimmten Gesamtableitungsimpedanzen durchgeführt wird. Durch diese Mittelung ist es möglich, die auf der Frequenzabhängigkeit der Gesamtableitungsimpedanz und der geringfügigen Differenz zwischen den Netz- sowie Meßfrequenzen beruhenden kleinen Meßfehler weiter zu vermindern. Dabei ist es besonders vorteilhaft, wenn ein Meßwechselstrom mit einer variablen Meßfrequenz überlagert wird, deren negative Abweichung von der Netzfrequenz geringfügig kleiner als ihre positive Abweichung von der Netzfrequenz ist. Somit kann der ohnehin recht kleine Meßfehler durch bessere Berücksichtigung der nichtlinearen Abhängigkeit der Impedanz von der Frequenz noch weiter reduziert werden.

In weiterer Ausgestaltung ist es möglich, einen um die Netzfrequenz herum frequenzmodulierten Meßwechselstrom zu überlagern. Dabei kann die Meßfrequenz des Meßwechselstroms zeitlich linear verändert werden. Auch hierbei läßt sich aus der Überlagerung die Gesamtleitungsimpedanz ableiten, wenn die Frequenzverschiebung so erfolgt, daß während einer Phase der vorgegebenen Überlagerungsfrequenz einmal Gleichphasigkeit und einmal Gegenphasigkeit der Signale vorliegt, damit sich auswertbare Minima und Maxima ausbilden können.

Alternativ wird vorgeschlagen, einen Wechselstrom von Netzfrequenz zu erzeugen, seine Phasenlage gegenüber dem Netz stetig zu verändern und diesen so modifizierten Wechselstrom als phasendynamischen Meßwechselstrom dem Netz einzuprägen. Auch in diesem Fall entsteht eine Schwebung, da alle relativen Phasenlagen durchlaufen werden, die bei 0° zu Maxima und bei 180° zu Minima führen. Da die dynamische Phasenverschiebung eine Geschwindigkeitsänderung des Meßwechselstrom-Zeigers und damit eine Frequenzänderung des Meßwechselstroms beinhaltet, muß die Phasenänderungsgeschwindigkeit ausreichend klein gegenüber der Netzfrequenz sein, damit eine exakte Impedanzmessung möglich ist.

Es ist besonders zweckmäßig, die Frequenz des Meßwechselstroms durch Frequenzvervielfachung und/oder -teilung aus der Netzfrequenz abzuleiten. Hierdurch ist es möglich, die Meßfrequenz der Netzfrequenz optimal, anzunähern und auch unter Berücksichtigung eventueller Netzfrequenzschwankungen eine gewissen minimalen Frequenzabstand aufrechtzuerhalten, der für die Ausbildung der Schwebung benötigt wird. Durch das Ableiten der Meßfrequenz aus der Netzfrequenz kann das Verhältnis Netzfrequenz zu Meßfrequenz immer konstant gehalten werden. Der geringe Frequenzabstand, der kleiner als die Größe der Netzfrequenzschwankungen sein kann, ermöglicht ein sehr genaues Erfassen der Gesamtableitungsimpdanz.

Vorzugsweise wird der Meßwechselstrom dem Netz mehrmolig symmetrisch eingeprägt. Diese mehrpolige, der Anzahl der vorhandenen Netzleiter entsprechende Einprägung ermöglicht es, daß der Innenwiderstand der Netzversorgung die Messung nicht beeinflußt. Durch die Symmetrie wird der Meßwechselstrom gleichmäßig verteilt. Grundsätzlich ist es jedoch auch möglich, den Meßwechselstrom nur einpolig einzuprägen.

In weiterer Ausgestaltung wird vorgeschlagen, daß die Netzankopplung für die Auswertung mehrpolig symmetrisch durchgeführt wird. Auch diese Maßnahme hat gewisse meßtechnische Vorteile.

Alternativ wird vorgeschlagen, daß die Netzankopplung für die Auswertung einpolig durchgeführt wird. In diesem Zusammenhang ist es ferner möglich, daß der Netzspannungsanteil des jeweiligen Netzleiters erfaßt wird und daß die Netzankopplung immer dann auf einen anderen Netzleiter mit höherem Netzspannungsanteil umgeschaltet wird, wenn der erfaßte Netzspannungsanteil kleiner als der durch den Meßwechselstrom und die minimale Gesamtableitungsimpedanz bestimmte minimale Meßspannungsanteil wird. Hierdurch kann normalerweise sichergestellt werden, daß stets der Meßwechselspannungsanteil den Netzspannungsanteil und nicht umgekehrt überlagert. Da die geometrische Addition der Netzspannungsanteile der Netzleiter gegen Erde immer die Netzspannung ergibt, wird beim Abfallen des Netzspannungsanteils an einem Netzleiter infolge unsymmetrisch verteilter Netzableitungen stets ein Netzleiter mit einem höheren Netzspannungsanteil vorhanden sein. Die einpolige Ankopplung gewährleistet ferner bei anliegender Netzspannung immer das Ausbilden einer Schwebung, und zwar im Unterschied zu einer mehrpoligen symmetrischen Ankopplung, bei der im Falle symmetrisch verteilter Netzableitungen der Netzspannungsanteil an der Meßstelle verschwindet.

Es ist bevorzugt, daß ein sinusförmiger Meßwechselstrom überlagert wird. Wenngleich auch grundsätzlich andere Formen eines Meßwechselstroms angewendet werden können, ermöglicht ein

3

sinusförmiger Meßwechselstrom das direkte Ausbilden einer Schwebung und Bestimmen der Gesamtableitungsimpedanz, ohne daß durch Fourier-Analyse erhaltene Grund- und Oberschwingungen des Meßwechselstroms berücksichtigt werden müssen.

Gegenüber einer ständigen Einprägung eines Meßwechselstroms besteht eine grundsätzlich andere vorteilhafte Vorgehensweise darin, daß der Meßwechselstrom getaktet wird, daß die sich bei aufgeprägtem Meßwechselstrom an der Meßstelle ergebende maximale Spannungsamplitude der Schwebung — bzw. bei verschwindender Netzwechselspannung der Meßwechselspannung — erfaßt wird, daß die sich bei unterbrochenem Meßwechselstrom an der Meßstelle ergebende Spannungsamplitude der Netzwechselspannung erfaßt wird und daß als Maß für die Gesamtableitungsimpedanz die Differenz dieser Spannungsamplituden gebildet wird. Hierdurch wird gewährleistet, daß unabhängig von der Einhaltung einer Amplitudenbedingung, das heißt unabhängig davon, ob der Meßwechselspannungsanteil den Netzspannungsanteil oder umgekehrt überlagert, stets die richtige Spannungsamplitude erfaßt wird. Wenn die Meßwechselspannung die Netzspannung überlagert, ergibt die Differenz die Spannungsamplitude der Schwebungshüllkurve. Wenn andererseits die Netzspannung die Meßwechselspannung überlagert, führt die Differenzbildung zu der zeitlich mittleren Spannungsamplitude der gesamten Schzebung, bei der die maximalen und minimalen Spannungsamplituden der Schwebung berücksichtigt sind. Wenn andererseits im spannungslosen Zustand des Wechselstromnetzes oder bei mehrpoliger Ankopplung der Auswertung sowie bei symmetrischer Verteilung der Netzableitungen an der Meßstelle der für die Schwebung erforderliche Netzspannungsanteil entfällt, ergibt sich dennoch der richtige Wert für die Bestimmung der Gesamtableitungsimpedanz, da dann eine Größe bei der Differenzbildung zu Null wird und lediglich die Meßwechselspannung in die Auswertung eingeht. Ein solches Verfahren ist somit völlig unabhängig von der Einhaltung einer Amplitudenbedingung zwischen dem Meßwechselspannungsanteil und dem Netzwechselspannungsanteil an der Meßstelle, also unabhängig von der Ausbildung einer Schwebung und unabhängig von der Art derselben.

Wenn der Meßwechselstrom dem Netz ständig überlagert wird, können die Spannungsmaxima sowie -minima der Schwebungshüllkurve nach dem Samplingprinzip erfaßt und die Differenz dieser Spannungswerte gebildet werden. Stattdessen ist es bei der ständigen Meßwechselstrom-Einspeisung auch möglich, daß die Schwebungsfrequenz ausgefiltert und die Spannungsamplitude der Hüllkurve bestimmt wird. In beiden Fällen führt die Auswertung dann, wenn in der Schwebung der Meßwechselspannungsanteil den Netzspannungsanteil überlagert, zum richtigen Wert der Gesamtableitungsimpedanz.

In weiterer Ausgestaltung des erfindungsgemäßen Verfahrens wird vorgeschlagen, daß die auf der Netzwechselspannung beruhende Maximalspannung der Netzleiter gegen Erde bestimmt sowie durch das der Gesamtableitungsimpedanz entsprechende Maß geteilt wird und daß der sich hierbei ergebende maximal mögliche Berührungsfehlerstrom zur Anzeige und/oder Auslösung gebracht wird. Diese Maßnahme ist insbesondere in medizinisch genutzten Räumen wichtig, da dann stets der maximale Strom angezeigt wird, der bei vorhandener Ableitungsimpedanz über eine Person fließen würde, die das Netz an der dafür ungünstigsten Stelle berührt.

Zur Lösung der gestellten Aufgabe wird ferner eine Einrichtung der im Oberbegriff genannten Art vorgeschlagen, die sich erfindungsgemäß durch eine gegenüber dem Wechselstromnetz phasendynamische Meßwechselstrom-Quelle, deren Meßwechselstrom bei annähernd Netzfrequenz eine sich in bezug auf das Wechselstromnetz ständig verändernde, bei anliegender Netzwechselspannung am Wechselstromnetz zu einer Schwebung führende Phasenlage hat, und durch eine Auswerteschaltung zum Bestimmen des auf dem Meßwechselstrom beruhenden Meßwechselspannungsanteils der Schwebung auszeichnet. Eine solche Einrichtung ist vergleichsweise einfach und ermöglicht es durch Ausbilden und Auswerten der Schwebung, daß die Meßfrequenz der Netzfrequenz optimal angepaßt und eine weitgehend auf die Netzfrequenz bezogene Gesamtableitungsimpedanz bestimmt werden kann. Eine dynamische Phasenverschiebung des Meßwechselstroms zum Erzielen der Schwebung bereitet keinerlei Schwierigkeiten und keinen besonders großen Schaltungsaufwand. Lediglich dann, wenn der Meßwechselstrom aus einer niederohmigen Quelle eingespeist wird, muß zusätzlich die jeweilige Amplitude des Meßwechselstroms für die Quotientenbildung gemäß dem übergeordneten Verfahrensanspruch erfaßt werden.

Es ist ferner bevorzugt, eine der Anzahl der Netzleiter entsprechend mehrpolige, gegenüber der Gesamtableitungsimpedanz hochohmige, symmetrische, Netzankopplung der Meßwechselstrom-Quelle vorzusehen. Während statt einer ohmschen auch eine beispielsweise kapazitive Netzankopplung benutzt werden kann, ermöglicht die genannte Hochohmigkeit der Netzankopplung eine weitgehende Amplitudenkonstanz des Meßwechselstroms, so daß ein Erfassen seiner Amplitude entfallen kann, die ihrerseits nur als Proportionalitätskonstante in das Meßergebnis der Gesamtableitungsimpedanz eingeht. Andererseits verhindert die Hochohmigkeit eine übermäßige Belastung des Netzes. Der durch den Isolationswächter selbst erzeugte Ableitstrom kann demnach durch eine sehr hohe Eigenimpedanz klein gehalten werden, was insbesondere beim Einsatz in medizinischen Netzen wichtig ist. Durch die hohe Eigenimpedanz muß andererseits der Meßwechselstrom klein gewählt werden, so daß der prozentuale Anteil der Meßwechselspannung an der Schwebung sehr klein werden kann und im ungünstigsten Fall beispielsweise nur 0,5 bis 1 Prozent beträgt. Und schließlich wird durch die mehrpolige Netzankopplung verhindert, daß der Innenwiderstand der Netzversorgung in das Meßergebnis eingeht.

Gemäß einer weiteren Ausführungsform wird eine über einen Schalter mit dem Netz verbindbare Meßwechselstrom-Quelle benutzt. Hierdurch ist es möglich, den Meßwechselstrom nur im Falle eines Meßvorgangs oder während desselben taktend einzuprägen, um durch die geschilderte Differenzbildung unabhängig von dem Auftreten und der Art einer Schwebung stets das richtige Meßergebnis zu erhalten.

Vorzugsweise wird eine Meßwechselstrom-Quelle mit sinusförmigem Meßwechselstrom benutzt, um eine möglichst einfach auswertbare Schwebung zu erzielen. Um frequenzbedingt auftretende Meßfehler in der geschilderten Weise ganz oder teilweise zu kompensieren, kann eine Meßwechselstrom-Quelle mit einem in bezug auf die Netzfrequenz zwischen positiven und negativen Frequenzabweichungen umschaltenden oder modulierten Meßfrequenz eingesetzt werden.

Da die Meßfrequenz der Netzfrequenz im Hinblick auf möglichst genaues Meßergebnis optimal angenähert sein sollte und andererseits auch unter Berücksichtigung eventueller Netzfrequenzschwankungen stets das Ausbilden einer Schwebung gewährleistet sein muß, ist es gemäß einer ersten Ausführungsform möglich, eine Meßwechselstrom-Quelle mit einem an die Netzfrequenz gekoppelten und hieraus die Meßfrequenz durch Frequenzvervielfachung und/oder -teilung bildenden Meßfrequenz-Erzeuger zu verwenden. Hierdurch kann ein nicht ganzzahliges, weitgehend dem Werte 1 angenähertes Teilerverhältnis der Meß- und Netzfrequenzen erzielt werden. Gemäß einer weiteren Ausführungsform ist es stattdessen möglich, einen an das Wechselstromnetz gekoppelten dynamischen Phasenschieber zum Erzeugen eines gegenüber dem Wechselstromnetz phasendynamischen Meßwechselstroms zu benutzen. Hierdurch kann unabhängig von auftretenden Schwankungen der Netzfrequenz ein bestimmter Frequenzabstand der Meßfrequenz eingehalten werden.

In weiterer Ausgestaltung wird eine gegenüber der Gesamtableitungsimpedanz hochohmige, spannungsvermindernde und nur Wechselspannungsanteile durchlassende Netzankopplung der Ausgeschaltung vorgeschlagen. Während die Hochohmigkeit dazu führt, daß die Ableitung über die Netzankopplung bei der Messung vernachlässigt werden kann, ermöglicht die Spannungsverminderung ein Herabsetzen der auszuwertenden Wechselspannungen auf ein für eine Elektronik geeignetes Niveau. Da die Netzankopplung nur Wechselspannungsanteile durchläßt, kann die Einrichtung zum Beispiel auch für Wechselstromnetze überlagerten Gleichspannung, beispielsweise für Mechoelstromnetze mit nachgeschalteten Gleichrichtern, und für Gleichstromnetze eingesetzt werden, sofern dort aus irgendwelchen Gründen die Gesamtableitungsimpedanz zu bestimmen ist.

Vorzugsweise besitzt die Einrichtung ferner einen Spannungsvergleicher und einen hiervon betätigten Schalter, der die jeweils einpolige Netzankopplung immer dann von einem Netzleiter auf einen anderen Netzleiter umschaltet, wenn die Netzwechselspannung des einen Netzleiters kleiner als eine bestimmte Vergleichsspannung oder kleiner als die Netzwechselspannung des anderen Netzleiters wird. Hierdurch kann die genannte Amplitudenbedingung eingehalten werden, so daß stets die Meßwechselspannung die Netzwechselspannung und nicht umgekehrt überlagert.

Bei einer weiteren Ausführungsform ist eine der Anzahl der Netzleiter entsprechend mehrpolige, symmetrische Netzankopplung vorgesehen. Vorzugsweise werden hierbei mit den einzelnen Netzableitungen eine Meßbrücke bildende ohmsche Ankopplungswiderstände und ein im Brückennullzweig liegender, an die Auswerteschaltung kapazitiv angekoppelter ohmscher Meßwiderstand benutzt. Eine solche Netzankopplung ist sehr übersichtlich und ermöglicht eine einfache Auswertung der Wechselspannungen unter Unterdrückung eventuell vorhandener Gleichspannungen am Wechselstromnetz. Es ist darauf hinzuweisen, daß die Ankopplungswiderstände nicht unbedingt ohmsch sein müssen und beispielsweise kapazitiv sein können.

Es ist möglich, eine den Meßwechselstrom während des Meßvorgangs ständig einspeisende Meßwechselstrom-Quelle zu verwenden und entweder eine durch Gleichrichten und Filtern die Schwebungsfrequenz ausfilternde sowie die Spannungsamplitude der Schwebungshüllkurve bestimmende Auswerteschaltung oder eine die Spannungsmaxima sowie -minima der Schwebungshüllkurve nach dem Samplingprinzip erfassende und deren Differenz bildende Auswerteschaltung zu benutzen. Im erstgenannten Fall muß wegen der Filterung der Betrag der Frequenzabweichung zwischen den Netz- und Meßfrequenzen klein gegenüber der Netzfrequenz sein. In beiden Fällen muß ferner die Amplitudenbedingung erfüllt sein, gemäß derer der Meßwechselspannungsanteil den Netzspannungsanteil und nicht umgekehrt in der Schwebung überlagern muß. Wenn im zweiten Fall die Auswerteschaltung nicht die Differenz, sondern das Spannungsmittel der Spannungsmaxima sowie -minima der Schwebungshüllkurve erfaßt, kann ferner diese Einrichtung auch dazu benutzt werden, die richtige Gesamtableitungsimpedanz bei nicht erfüllter Amplitudenbedingung zu bestimmen, also wenn die Netzspannung die Meßwechselspannung in der Schwebung überlagert.

Stattdessen können eine den Meßwechselstrom taktend einspeisende Meßwechselstrom-Quelle und eine Auswerteschaltung mit einem Spitzenspannungsdetektor zum Erfassen der an der Meßstelle jeweils mit und ohne Meßwechselstrom-Einspeisung auftretenden Spannungsmaxima eingesetzt werden, und zwar in Verbindung mit zwei an den Spitzenspannungsdetektor abwechselnd anschließbaren Übernahmespeichern zum vorübergehenden Speichern der Spannungsmaxima und durch einen Differenzbildner zum Bestimmen der Differenz der gespeicherten Spannungsmaxima. Diese Einrichtung ist wiederum unabhängig von der Ausbildung und von der Art der Schwebung, also beispielsweise unabhängig von der Verteilung der Netzableitungen und von der Einhaltung der genannten Amplitudenbedingung.

Ferner ist es bevorzugt, eine Sicherheitsschaltung mit einem Maximalspannung-Detektor zum Bestimmen der maximalen Leiterspannung des Wechselstromnetzes gegenüber Erde und einen Analogdividierer zum Dividieren dieser maximalen Leiterspannung durch die von der Auswerteschaltung bestimmte Gesamtableitungsimpedanz zu benutzen. Hierdurch kann in der bereits geschilderten Weise der maximal mögliche Leiterberührungsstrom bestimmt werden.

Vorzugsweise besitzt die Einrichtung ferner Anzeige- und/oder Warn- und/oder Auslösemittel für die Gesamtableitungsimpedanz und/oder den maximalen Leiterberührungsstrom. Hierdurch ist eine ständige, sichere Betriebsüberwachung des Wechselstromnetzes möglich. Wenn es erwünscht ist, kann zusätzlich zu dem maximalen Leiterberührungsstrom natürlich auch derjenige Netzleiter angezeigt werden, bei dessen Berührung dieser maximale Leiterberührungsstrom fließen würde. Dabei handelt es sich um den Netzleiter, an dem bei unsymmetrischer Verteilung der Netzableitungen die größte Leiterspannung auftritt.

Damit der Meßfehler der auf die Netzfrequenz zu beziehenden Gesamtableitungsimpedanz nicht zu groß wird bzw. durch zu aufwendige Maßnahmen ausreichend kompensiert werden muß, ist es vorteilhaft, eine Meßwechselstrom-Quelle mit einer von der Netzfrequenz um bis etwa zehn Prozent abweichenden Meßfrequenz zu verwenden. Demnach kann beispielsweise bei einer Netzfrequenz von 50 Hertz eine Meßfrequenz von 53 Hertz benutzt werden, was bei einer rein kapazitiven Netzableitung zu einem maximalen Meßfehler von ca. fünf Prozent führt. Dieser Meßfehler kann durch umschaltendes oder modulierendes Verändern der Meßfrequenz um die Netzfrequenz in der geschilderten Weise reduziert werden.

Das erfindungsgemäße Verfahren und die zum Durchführen desselben dienende erfindungsgemäße Einrichtung ermöglichen somit in relativ einfacher Weise ein sehr genaues Bestimmen der auf die Netzfrequenz bezogenen Gesamtableitungsimpedanz eines Wechselstromnetzes durch Ausnutzen der Ausbildung einer Schwebung zwischen dem Netzspannungsanteil und dem phasendynamisch überlagerten Meßwechselspannungsanteil, dessen Meßfrequenz der Netzfrequenz optimal angenähert ist.

Die Erfindung wird nachfolgend unter Bezugnahme auf die Zeichnungen und an einzelnen, schematisch dargestellten Ausführungsbeispielen näher erläutert. Es zeigen :

Figur 1   ein ungeerdetes Wechselstromnetz mit im vorliegenden Fall zwei ableitungsbehafteten Netzleitern und einer zweipoligen, ohmschen, symmetrischen Ankopplung einer phasendynamischen Meßwechselstrom-Quelle an das Wechselstromnetz,

Figur 2   ein die Meßwechselstrom-Einspeisung aus Figur 1 betreffendes Ersatzschaltbild,

Figur 3   in einer zeichnerischen Prinzipdarstellung eine Schwebung der an den Netzableitungen auftretenden Netzwechselspannungs- sowie Meßwechselspannungsanteile und die einzelnen Komponenten der Schwebung,

Figur 4   in einer schematischen Zeigerdarstellung die die Netzableitungen durchfließenden, sich geometrisch addierenden Ströme und deren relative Phasenlagen,

Figur 5   eine erste praktische Ausführungsform einer Einrichtung mit einer ständigen Meßwechselstrom-Einspeisung, einer filternden Auswertung der Schwebungshüllkurve und einer Umschaltung einer einpoligen Netzankopplung zwischen den einzelnen Netzleitern in Abhängigkeit von der jeweiligen Netzleiter-Netzspannungsamplitude,

Figur 6   eine zweite Ausführungsform einer Einrichtung nach der vorliegenden Erfindung mit einer taktenden Meßwechselstrom-Einspeisung und einer im vorliegenden Fall zweipoligen Ankopplung einer unabhängig von der Einhaltung einer Amplitudenbedingung arbeitenden Auswerteschaltung,

Figur 7   im Zusammenhang mit der Einrichtung aus Figur 6 ein deren Meßwechselstrom-Einspeisung und Netzankopplung der Auswerteschaltung betreffendes Ersatzschaltbild,

Figur 8   ein die Betätigung von verschiedenen Schaltern der Einrichtung aus Figur 6 betreffendes Zeitdiagramm und

Figur 9   eine dritte Ausführungsform mit einem im vorliegenden Fall dreiphasigen Wechselstromnetz, einer während des Meßvorgangs ständigen Einprägung eines Meßwechselstroms, einer einpoligen sowie netzspannungsabhängig zwischen zwei Netzleitern umschaltenden Netzankopplung der Auswerteschaltung für die Gesamtableitungsimpedanz und einer dreipolig angekoppelten Sicherheitsschaltung zum Erfassen des maximal möglichen Leiterberührungsstroms.

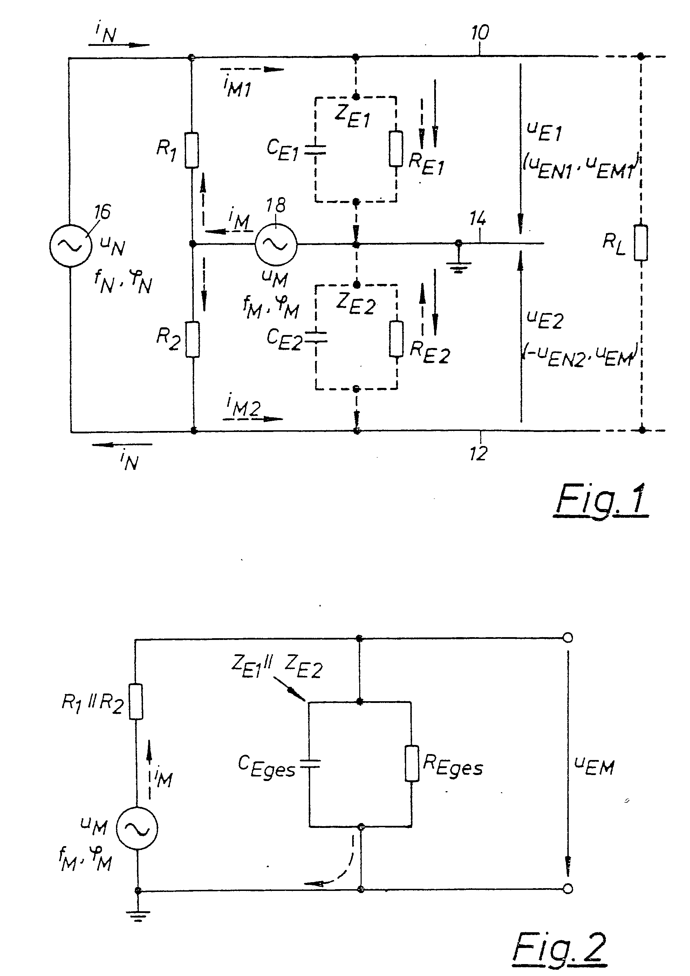

Nachfolgend wird zunächst das Prinzip des erfindungsgemäßen Verfahrens unter Bezugnahme auf die Figuren 1 bis 4 erläutert, und zwar aus Einfachheitsgründen an einem isolierten Wechselstromnetz mit zwei Netzleitern 10, 12, die mit Erde 14 keine direkte Verbindung haben. Gemäß Figur 1 speist eine Netzwechselspannungsquelle 16 über die Netzleiter 10, 12 eine gestrichelt dargestellte Last $R_L$. In unvermeidbarer Weise befinden sich stets zwischen den Netzleitern 10, 12 und Erde 14 Netzableitungen. Diese bestehen aus kapazitiven sowie ohmschen Komponenten und sind für den Netzleiter 10 zu einer Netzableitungsimpedanz $Z_{E1}$ mit $C_{E1}$ sowie $R_{E1}$ und für den Netzleiter 12 zu einer Netzableitungsimpedanz $Z_{E2}$ mit $C_{E2}$ sowie $R_{E2}$ zusammengefaßt. Die Netzwechselspannungsquelle 16 treibt einen Netzableitungsstrom durch die Reihenschaltung der Netzableitungsimpedanzen $Z_{E1}$ und $Z_{E2}$, was mit durchgezogen dargestellten Pfeilen angedeutet ist. Demnach nehmen die Netzleiter 10 und 12 gegenüber Erde 14 Spannungspotentiale $u_{EN1}$ und $u_{EN2}$ an, die sich jeweils zu dem Spannungspotential $u_N$ der Netzwechselspannungsquelle 16 addieren und bezüglich ihrer Einzelgrößen von der Größenrelation der Netzableitungsimpedanzen $Z_{E1}$ und $Z_{E2}$ abhängen.

Es ist bekannt, daß der maximale Fehlerstrom, der beim Berühren eines Netzleiters, also im

6

vorliegenden Fall des Netzleiters 10 oder des Netzleiters 12, fließt, dem Quotienten aus der maximalen Netzleiterspannung und der Gesamtableitungsimpedanz entspricht. Es gilt also

$$|i_{Emax}| = |u_{ENmax}|/|Z_{Eges}| \tag{1}$$

Bei symmetrischer Verteilung der einzelnen Netzableitungen $Z_{E1}$ und $Z_{E2}$ sind die auf der Netzversorgung beruhenden Leiterspannungen $u_{EN1}$ und $u_{EN2}$ gleich groß. Die Gesamtableitungsimpedanz entspricht der Parallelschaltung der einzelnen Netzableitungsimpedanzen $Z_{E1}$ und $Z_{E2}$. Es gilt demnach:

$$|Z_{Eges}| = |Z_{E1}||Z_{E2}| = \sqrt{((R_{E1} \cdot R_{E2})/(R_{E1} + R_{E2}))^2 + [\omega(C_{E1} + C_{E2})]^2} \tag{2}$$

Da demnach die Gesamtableitungsimpedanz des Wechselstromnetzes für die Betriebssicherheit eines ungeerdeten Wechselstromnetzes von größter Wichtigkeit ist, gilt es, die Größe dieser Gesamtableitungsimpedanz zu überwachen.

Im netzspannungslosen Zustand des Wechselstromnetzes ist ein Erfassen der Gesamtableitungsimpedanz relativ unproblematisch. Da das Netz einen sehr kleinen Innenwiderstand hat, kann man es gegenüber Erde als eine « Schiene » auffassen. Zwischen Netz und Erde kann dann gemäß Figur 1 ein Meßwechselstrom $i_M$ eingespeist werden, der gemäß dem Ersatzschaltbild aus Figur 2 die Gesamtableitungsimpedanz durchfließt und an dieser einen Spannungsabfall $u_{EM}$ hervorruft. Die Gesamtableitungsimpedanz kann dann aus follgender Gleichung

$$|Z_{Eges}| = |u_{EM}|/|i_M| \tag{3}$$

berechnet werden. Bei Einspeisung eines amplitudenkonstanten Meßwechselstroms $i_M$ ist demnach die Gesamtableitungsimpedanz proportional zu der auf dem Meßwechselstrom beruhenden gemessenen Netzleiterspannung $u_{EM}$, wobei es wegen der durchgehenden « Schiene » des Netzes gleichgültig ist, ob die Netzleiterspannung zwischen dem Netzleiter 10 oder dem Netzleiter 12 und Erde 14 gemessen wird. Gemäß Figur 2 wird die Größe des Meßwechselstroms $i_M$ nur durch die Parallelschaltung der Ankopplungswiderstände $R_1$ und $R_2$ bestimmt, wenn deren Gesamtwiderstand sehr viel größer als die Gesamtableitungsimpedanz ist. Sofern dieses nicht zutrifft, müßte stets auch noch die Größe des Meßwechselstroms zum Bestimmen der Gesamtableitungsimpedanz festgestellt und berücksichtigt werden.

Im Betriebszustand des Wechselstromnetzes werden die einzelnen Netzableitungen $Z_{E1}$ und $Z_{E2}$ gemäß Figur 1 einerseits von dem Meßwechselstrom bzw. einem Teil desselben und andererseits von einem unbekannten Netzwechselstrom $i_N$ durchflossen. Demnach nehmen die einzelnen Netzleiter 10, 12 gegenüber Erde 14 Leiterspannungen $u_{E1}$, $u_{E2}$ an, die jeweils aus zwei überlagerten Spannungsanteilen einerseits mit Netzfrequenz $f_N$ und andererseits mit Meßfrequenz $f_M$ bestehen. Während die auf der Netzversorgung beruhenden Spannungsanteile $u_{EN1}$, $u_{EN2}$ aus den genannten Grüden bezüglich ihrer Einzelgrößen von der Verteilung bzw. Relation der Netzableitungen $Z_{E1}$, $Z_{E2}$ abhängen und sich jeweils zu der Gesamtspannung $u_N$ addieren, sind die auf dem Meßwechselstrom basierenden Spannungsanteile $u_{EM}$ in $u_{E1}$ und $u_{E2}$ identisch.

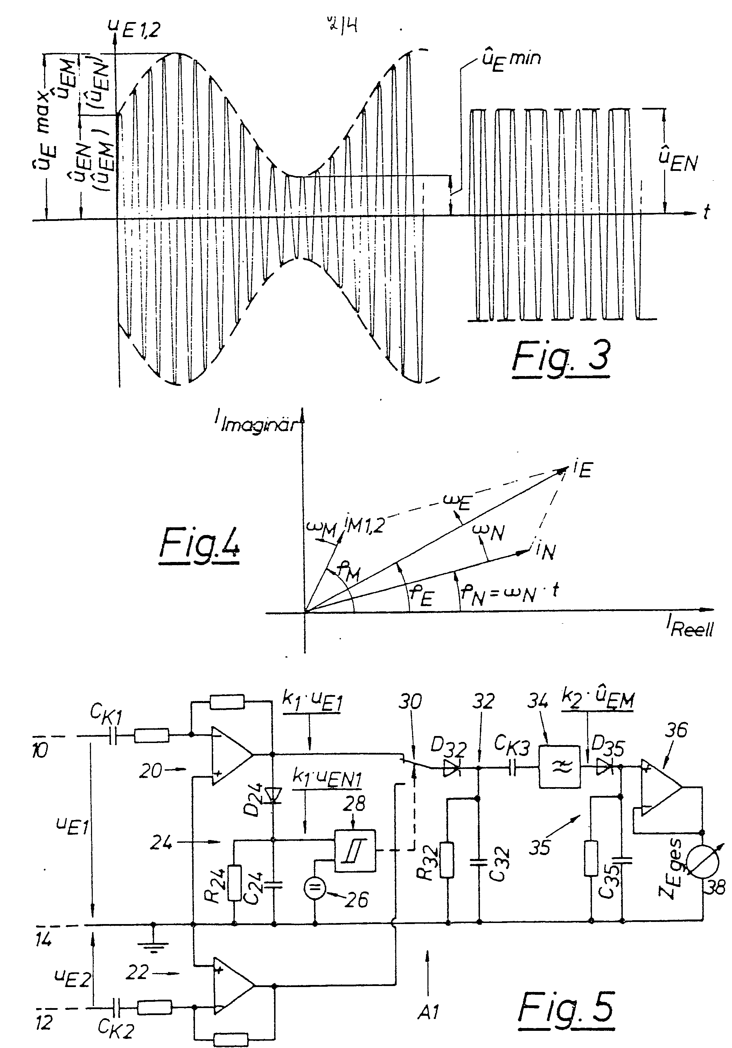

In dem Zeigerbild aus Figur 4 ist dargestellt, daß sich in jeder Netzableitung $Z_{E1}$, $Z_{E2}$ jeweils der netzbedingte Wechselstrom $i_N$ und der Meßwechselstrom bzw. ein durch die Größe der Ankopplungswiderstände $R_1$, $R_2$ bestimmter Anteil $i_{M1}$ bzw. $i_{M2}$ desselben geometrisch zu einem Gesamtstrom $i_E$ addieren, der die entsprechende Leiterspannung $u_{E1}$ bzw. $u_{E2}$ hervorruft. Diese Leiterspannung ergibt sich auch durch Addition derjenigen Spannungsanteile, die durch die die Netzableitung durchfließenden Einzelströme bewirkt werden.

Wenn die in der Netzableitung überlagerten Einzelströme keine feste Phasenbeziehung zueinander haben, das heißt wenn das Teilerverhältnis ihrer Frequenzen nicht ganzzahlig ist, und wenn die Frequenzen dicht beieinander liegen, ergibt sich für den Gesamtstrom bzw. die hierdurch (oder durch die Einzelströme) erzeugte Leiterspannung $u_{E1}$ oder $u_{E2}$ eine Schwebung gemäß Figur 3, linker Teil. Aus dieser Schwebung können die von den Einzelströmen bewirkten einzelnen Spannungsanteile, also insbesondere auch der für die Bestimmung der Gesamtableitungsimpedanz maßgebliche Spannungsanteil $u_{EM}$, bestimmt werden.

Aus dem Zeigerbild gemäß Figur 4 ist ersichtlich, daß der Absolutwert des Gesamtstroms $i_E$ (bzw. der hierdurch bedingten jeweiligen Leiterspannung) von dem augenblicklichen, sich ständig ändernden Phasenunterschied zwischen den Einzelströmen (bzw. den hierdurch bedingten Spannungsanteilen) abhängt. Bei der geometrischen Addition entsteht ein Maximum bei Phasengleichheit und ein Minimum bei einem Phasenunterschied von 180°, da sich dann die Zeiger jeweils algebraisch addieren bzw. subtrahieren. Wenn die Einzelströme jeweils eine konstante Frequenz $f_N$ bzw. $f_M$ haben und somit in der Darstellung aus Figur 4 mit konstanter Kreisfrequenz $\omega_N$ bzw. $\omega_M$ umlaufen, ändert sich die Amplitude des resultierenden Zeigers zeitlich mit der Differenzfrequenz $|f_N - f_M|$. Der resultierende Zeiger $i_E$ läuft mit einer zeitlich veränderlichen Kreisfrequenz $\omega_E$ um. Entsprechendes gilt für die einander überlagerten Spannungsanteile.

Die Schwebung aus Figur 3, linke Seite, setzt sich somit folgendermaßen zusammen : Die sich aus den einzelnen Spannungsanteilen $u_{EN}$ sowie $u_{EM}$ mit den Frequenzen $f_N$ sowie $f_M$ zusammensetzende Leiterspannung $u_E$ hat insgesamt wie der Zeiger $i_E$ aus Figur 4 eine hier nicht interessierende zeitlich variable Frequenz. Es erfolgt eine periodische Änderung der Amplitude der Leiterspannung mit der sogenannten Schwebungsfrequenz, die der genannten Differenzfrequenz $|f_M - f_N|$ entspricht. Die Spannungsmaxima $u_E$ max und Spannungsminima $u_E$ min entstehen immer dann, wenn Gleichphasigkeit bzw. Gegenphasigkeit zwischen den einzelnen, einander überlagerten Spannungsanteilen (bzw. zwischen den Einzelströmen) vorliegt.

Da gemäß Figur 1 die einzelnen Netzableitungen von dem durch die Netzversorgung bedingten Netzwechselstrom in Reihe durchflossen werden, während sie von dem Meßwechselstrom bzw. dessen Teilen parallel durchströmt werden, unterscheiden sich die Schwebungsbilder der einzelnen Leiterspannungen $u_{E1}$ und $u_{E2}$ bei symmetrisch verteilten Netzableitungen nur durch eine gegenseitige Phasenverschiebung von 180°. Demnach kann der zur Bestimmung der Gesamtableitungsimpedanz · maßgebliche Spannungsanteil $u_{EM}$ aus dem Schwebungsbild des Netzleiters 10 oder des Netzleiters 12 bestimmt werden. Wenn die Netzableitungen unsymmetrisch verteilt sind, ändern sich die Schwebungsbilder für die Netzleiter 10 und 12 über das bereits Gesagte hinausgehend nur durch die Größe des jeweiligen Netzspannungsanteils $u_{EN}$.

Die einzelnen Spannungsanteile der Leiterspannung $u_E$ lassen sich aus dem Schwebungsbild gemäß Figur 3 direkt ablesen. Die Spannungsamplitude jeder der beidseitigen Schwebungshüllkurven entspricht der Spannungsamplitude des für die Gesamtableitungsimpedanz maßgeblichen Spannungsanteils $u_{EM}$, solange dieser Spannungsanteil kleiner als der Netzspannungsanteil $u_{EN}$ ist. In diesem Fall entspricht die zeitlich mittlere Spannungsamplitude der Schwebung selbst der Spannungsamplitude des Netzspannungsanteils $u_{EN}$. Wenn dagegen der Netzspannungsanteil $u_{EN}$ kleiner als der Meßspannungsanteil $u_{EM}$ ist, entsprechen die Spannungsamplitude der Schwebungshüllkurve derjenigen des Netzspannungsanteils $u_{EN}$ und die zeitlich mittlere Spannungsamplitude der Schwebung selbst derjenigen des maßgeblichen Meßspannungsanteils $u_{EM}$. Bei Gleichheit der Netz- und Meßspannungsanteile erfolgt eine gegenseitige Berührung der beiden Schwebungshüllkurven, und die Amplituden der Spannungsanteile ergeben sich dann sowohl aus der Spannungsamplitude der Schwebungshüllkurve wie auch aus der zeitlich mittleren Spannungsamplitude der Schwebung selbst.

Um ein Schwebungsbild gemäß Figur 3 zu erhalten, muß demnach dem Wechselstromnetz ein über die Netzableitungen fließender Meßwechselstrom mit einer dynamischen Phasenverschiebung gegenüber dem entsprechenden Netzwechselstrom eingespeist werden. Die stetige Veränderung der gegenseitigen Phasenlage muß ausreichend langsam erfolgen, das heißt die Meß- und Netzfrequenzen $f_M$ sowie $f_N$ müssen ausreichend dicht beieinander liegen, damit sich eine auswertbare Schwebungshüllkurve mit der Differenzfrequenz ergibt.

Wie es bereits ausgeführt wurde, ist der Spannungsanteil $u_{EM}$ bei amplitudenkonstanter Wechselstromeinspeisung ein Maß für die Gesamtableitungsimpedanz. Wenn sich der eingespeiste Meßwechselstrom amplitudenmäßig ändert, muß seine Größe gemessen und bei der Bestimmung der Gesamtableitungsimpedanz durch entsprechende Quotientenbildung berücksichtigt werden. Da die Gesamtableitungsimpedanz frequenzabhängig ist, sollte auch aus diesem Grunde die Meßfrequenz möglichst nahe bei der Netzfrequenz liegen, das heißt die Geschwindigkeit der dynamischen Phasenverschiebung sollte möglichst klein sein, damit der Unterschied zwischen der Gesamtableitungsimpedanz bei exakt Netzfrequenz und bei Meßfrequenz möglichst klein ist.

Der geringe Meßfehler, der durch die für das Ausbilden der Schwebung erforderliche geringfügige Differenzfrequenz hervorgerufen wird, kann in der bereits erläuterten Weise dadurch vermindert werden, daß eine Mittelung der bei unterschiedlichen Meßfrequenzen oberhalb und unterhalb der Netzfrequenz bestimmten Gesamtableitungsimpedanzen vorgenommen wird. Dabei kann die Meßfrequenz ständig umgeschaltet oder auch kontinuierlich verändert werden, gegebenenfalls in Verbindung mit unterschiedlichen Frequenzabweichungen oberhalb und unterhalb der Netzfrequenz, um nichtlineare Frequenzabhängigkeiten zu kompensieren.

Bei der Ausführungsform gemäß Figur 5 wird das Schwebungsbild der Leiterspannung $u_{E1}$ des Leiters 10 aus Figur 1 gegenüber Erde 14 solange ausgewertet, wie der zugehörige Netzspannungsanteil $u_{EN1}$ größer als eine bestimmte Vergleichsspannung ist. Anderenfalls erfolgt ein Umschalten auf den anderen Netzleiter 12, so daß dann das Schwebungsbild der Leiterspannung $u_{E2}$ ausgewertet wird. Das hat folgenden Grund : Damit die Spannungsamplitude der Schwebungshüllkurve dem für die Gesamtableitungsimpedanz maßgeblichen Spannungsanteil $u_{EM}$ entspricht, muß dieser Spannungsanteil kleiner als der Netzspannungsanteil $u_{EN}$ oder maximal gleich diesem Anteil sein. Wenn nun der Netzspannungsanteil $u_{EN1}$ des Netzleiters 10 zu klein wird, also die genannte Amplitudenbedingung nicht mehr erfüllt ist, gilt diese Amplitudenbedingung jedoch für den anderen Netzleiter 12, da die Summe der beiden Netzspannungsanteile $u_{EN1}$ und $u_{EN2}$ immer der gesamten Netzspannung $u_N$ entspricht.

Gemäß Figur 5 ist der Netzleiter 10 bzw. 12 über einen Ankopplungskondensator $C_{K1}$ bzw. $C_{K2}$ und einen geeigneten hochohmigen Spannungsminderer 20 bzw. 22 mit einem Schalter 30 verbunden. Am Ausgang des Spannungsminderers 20 steht ein ausreichend kleiner Anteil $k_1 \cdot u_{E1}$ der Leiterspannung $u_{E1}$ zur Verfügung. Zwischen dem Ausgang des Spannungsminderers 20 und Erde 14 befindet sich ein Gleichrichter und Mittelwertbildner 24 mit einer Diode D24, der eine Parallelschaltung mit einem Kondensator C24 und einem Widerstand R24 in Reihe geschaltet ist. Der am Kondensator C24 entstehende Mittelwert $k_1 \cdot u_{EN1}$ ist ein Maß für den am Netzleiter 10 anstehenden Netzspannungsanteil $u_{EN1}$ und wird zusammen mit der Ausgangsspannung einer Bezugsspannungsquelle 26 einem Schwellwertschalter 28 zugeführt. Dieser sorgt für ein Umschalten des Schalters 30 von dem Netzleiter 10 auf den Netzleiter 12 immer dann, wenn der Mittelwert am Kondensator C24 kleiner als die Bezugsspannung $U_{ref}$ wird. Die Bezugsspannung $U_{ref}$ kann in folgenden Grenzen gewählt werden :

$$|k_1| \cdot |i_M \cdot Z_{E \; ges \; min}| \leq U_{ref} \leq (|k_1| \cdot |u_N|)/2 \qquad (4)$$

Die obere Grenze gibt an, daß ein Umschalten vom Netzleiter 10 auf den Netzleiter 12 immer dann erfolgen kann, wenn der Netzspannungsanteil $u_{EN1}$ kleiner als die halbe Netzspannung $u_N$ wird, was nur im Falle unsymmetrisch verteilter Netzableitungen der Fall sein kann. Die untere Grenze ist von der minimal auszuwertenden Gesamtableitungsimpedanz abhängig und besagt, daß ein Umschalten vom Netzleiter 10 auf den Netzleiter 12 immer dann erfolgen muß, wenn der Netzspannungsanteil $u_{EN1}$ kleiner als der minimal am Netz auftretende Meßspannungsanteil $u_{EM \; min}$ wird. Dieser minimal auftretende Meßspannungsanteil hängt bei vorgegebenem Meßwechselstrom von der Größe der zu erfassenden minimalen Gesamtableitungsimpedanz ab.

Gemäß Figur 5 folgt dem Schalter 30 eine Gleichrichterschaltung 32 mit einer Diode D32 und einer deren Ausgang mit Erde 14 verbindenden Parallelschaltung aus einem Kondensator C32 und einem Widerstand R32. Die Zeitkonstante dieser Schaltung wird wie folgt gewählt :

$$\tau = C32 \cdot R32 \leq 1/(|f_N - f_M|) \qquad (5)$$

Die dabei entstehende Gleichspannung ist die noch Netzanteile mit $f_N$ enthaltende Überlagerungsspannung. Der nachgeschaltete Kondensator $C_{K3}$ koppelt die Wechselspannungsanteile aus. Ein auf die Differenzfrequenz $|f_N - f_M|$ abgestimmter Tiefpaß 34 läßt nur den Anteil der Überlagerungsspannung, das heißt $k_2 \cdot \hat{u}_{EM'}$, passieren. Diese Überlagerungsspannung wird in einem Gleichrichter 35 mit einer Reihenschaltung aus einer Diode D35 und einem Kondensator C35 gleichgerichtet und in eine Gleichspannung umgewandelt, die proportional der Gesamtableitungsimpedanz $Z_{E \; ges}$ ist. Diese Gleichspannung kann mit einem Verstärker 36 verstärkt und mit einem in $Z_{E \; ges}$ geeichten Anzeigeinstrument 38 angezeigt werden.

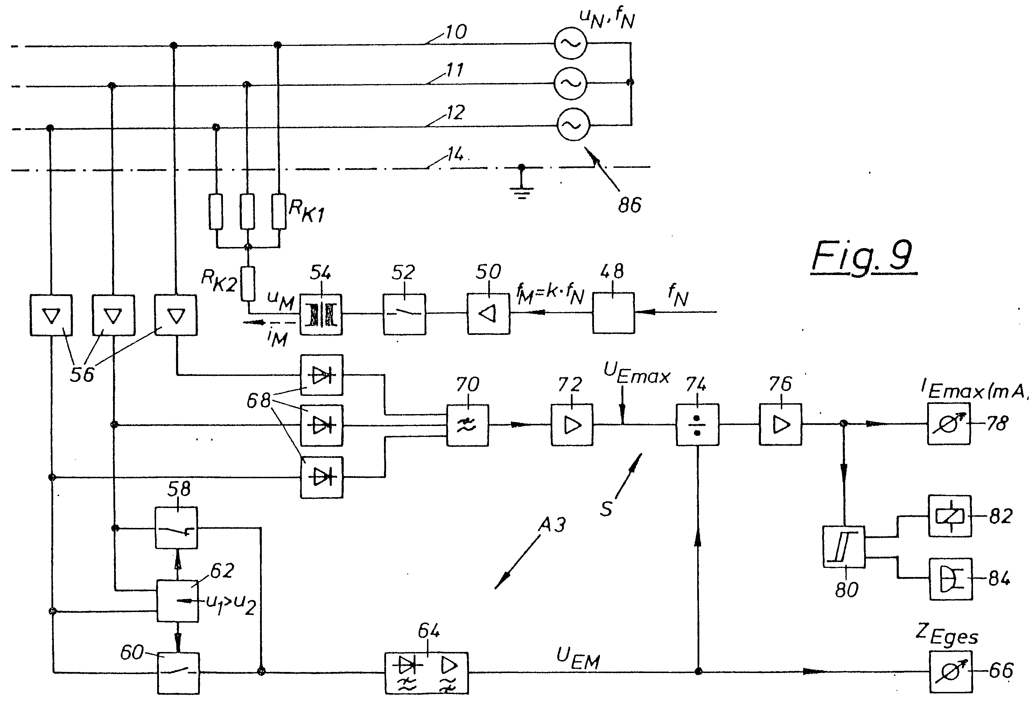

Die Ausführungsform aus Figur 5 kann grundsätzlich auch für Wechselstromnetze mit drei Netzleitern benutzt werden. Die Einspeisung des Meßwechselstroms würde dann analog zu Figur 1 und entsprechend Figur 9 dreipolig erfolgen, während es genügt, die Auswerteschaltung A1 entsprechend Figur 9 im Bedarfsfall nur zwischen zwei Netzleitern umzuschalten. Allerdings muß dann die obere Grenze für die Umschaltschwelle bzw. Vergleichsspannung $U_{ref}$ anders gewählt werden, indem in Gleichung 4 der Nennerwert « 2 » durch « $\sqrt{3}$ » ersetzt wird.

Statt der mit der Ausführungsform aus Figur 5 erfolgenden filternden Auswertung der Schwebung kann die für die Bestimmung der Gesamtableitungsimpedanz maßgebliche Spannungsamplitude der Schwebungshüllkurve auch dadurch bestimmt werden, daß die Spannungsmaxima und -minima der Hüllkurve erfaßt werden. Durch Differenzbildung und Halbierung ergibt sich dann die benötigte Spannungsamplitude.

Wenn die vorgenannte Amplitudenbedingung nicht erfüllt ist und sich somit die Überlagerung der Schwebung umkehrt, kann die für die Gesamtableitungsimpedanz maßgebliche Spannungsamplitude auch dadurch bestimmt werden, daß die zeitlich mittlere Spannungsamplitude der Schwebung selbst erfaßt wird. Dieses kann beispielsweise im Samplingverfahren durch Erfassen und Mitteln der Spannungsmaxima sowie -minima erfolgen. Auch wäre es möglich, die Schwebung gleichzurichten und dann eine geeignete Mittelwertbildung durchzuführen.

Im Zusammenhang mit der filternden Ausführungsform aus Figur 5 ist noch anzufügen, daß diese nur bei vorhandener Netzwechselspannung arbeitet, da sich ohne diese keine Überlagerung ausbilden kann. In nicht dargestellter Weise könnte die Ausführungsform aus Figur 5 so modifiziert werden, daß bei Wegfall der Netzspannung die am Schalter 30 anstehende Spannung über einen dann zu schließenden Schalter direkt dem Eingang des Gleichrichters 35 zugeführt und nach Gleichrichtung sowie Verstärkung als $Z_{E \; ges}$ angezeigt wird.

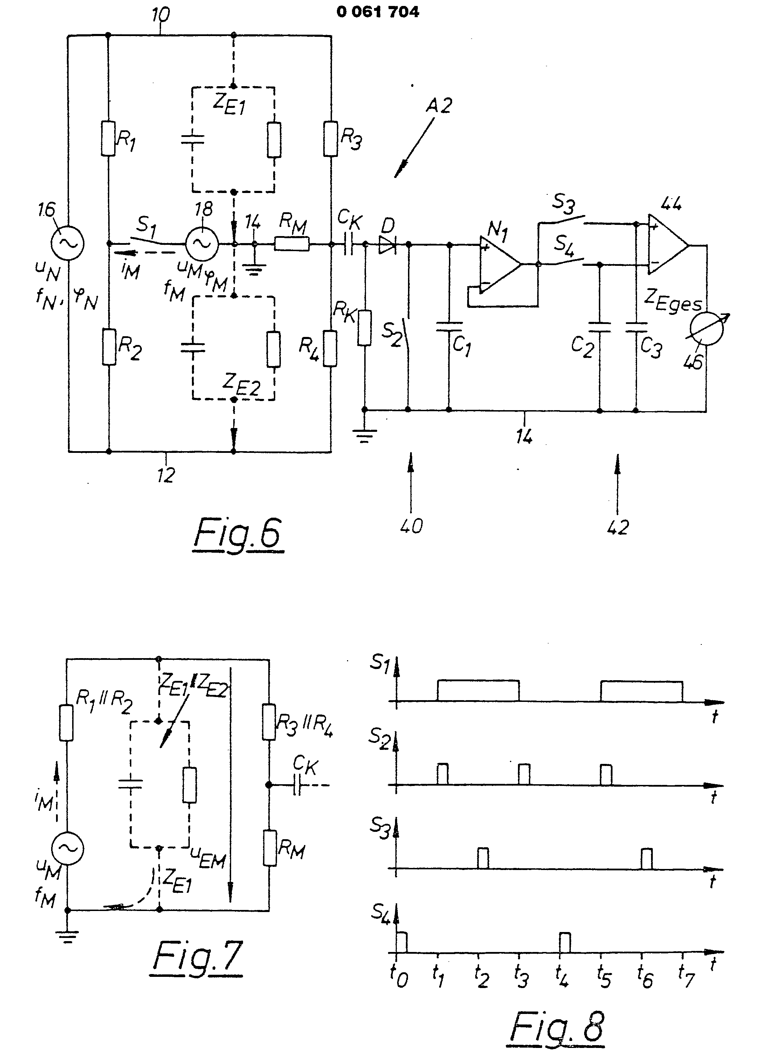

Bei der Ausführungsform aus Figur 6, die aus Einfachheitsgründen ebenfalls in Verbindung mit einem ungeerdeten Wechselstromnetz mit nur zwei Netzleitern 10, 12 dargestellt ist, spielt die Einhaltung einer Amplitudenbedingung keine Rolle für die richtige Erfassung der Gesamtableitungsimpedanz. Außerm wird das Meßergebnis auch nicht beeinflußt, wenn die Netzspannung wegfällt. Die Meßwechselstrom-Quelle 18 ist im Unterschied zu Figur 1 über einen Schalter S1 mit dem Verbindungspunkt der hochohmigen, wie bei Figur 1 vorzugsweise gleich großen, Ankopplungswiderstände R1, R2 verbunden. Demnach kann gemäß Figur 6 die Einspeisung bzw. Einprägung des Meßwechselstroms getaktet, also ein- und ausgeschaltet, werden.

Bei der Ausführungsform aus Figur 6 sind die Netzleiter 10 und 12 über zwei in Reihe geschaltete, hochohmige Ankopplungswiderstände R3 und R4 miteinander verbunden. Der Verbindungspunkt dieser beiden Widerstände ist einerseits über einen Meßwiderstand $R_M$ mit Erde 14 und andererseits über einen Kondensator $C_K$ mit einer Auswerteschaltung A2 verbunden. Das Ersatzschaltbild für die Einspeisung des Meßwechselstroms und die Auskopplung des für die Bestimmung der Gesamtableitungsimpedanz entsprechenden Meßspannungsanteils ergibt sich aus Figur 7. Die Parallelschaltungen von R1 sowie R2 einerseits und R3 sowie R4 andererseits sollten gegenüber der Gesamtableitungsimpedanz jeweils möglichst hochohmig sein, damit geringe Netzbelastungen durch die Überwachungseinrichtung entstehen, derner die Größe des Meßwechselstroms möglichst unabhängig von der Größe der Gesamtableitungsimpedanz wird und die Überlagerungsvorgänge nicht durch die Auswerteschaltung beeinflußt werden.

Der Meßwiderstand $R_M$ liegt im Brückennullzweig einer Brücke mit den Ableitimpedanzen $Z_{E1}$, $Z_{E2}$ einerseits und den Ankopplungswiderständen R3, R4 andererseits. Bei offenem Schalter S1 und symmetrischer Verteilung der Ableitungsimpedanzen fällt an $R_M$ keine Spannung ab. Bei geschlossenem Schalter S1 wird in der bereits beschriebenen Weise ein amplitudenkonstanter Meßwechselstrom eingeprägt, der an der Gesamtableitungsimpedanz, also im vorliegenden Fall an der Parallelschaltung von $Z_{E1}$ und $Z_{E2}$, den für die Bestimmung der Gesamtableitungsimpedanz maßgeblichen Meßspannungsanteil $u_{EM}$ entstehen läßt. Dieser Meßspannungsanteil wird durch die Ankoppelwiderstände R3, R4 sowie $R_M$ auf ein für die Elektronik passendes Spannungsmaß herabgesetzt, das über $C_K$, $R_K$ ausgekoppelt wird. $C_K$ eliminiert Gleichspannungsanteile, so daß auch diese Einrichtung für Gleichstromnetze bzw. Wechselstromnetze mit direkt angeschlossenen Gleichrichtern eingesetzt werden kann.

Da bei exakt symmetrisch verteilten Ableitungsimpedanzen und gleich großen Ankopplungswiderständen R3, R4 an $R_M$ keinerlei Netzspannungsanteil ansteht und bei geschlossenem Schalter S1 bzw. bei eingeprägtem Meßwechselstrom denach nur der zur Gesamtableitungsimpedanz proportionale Meßspannungsanteil ausgekoppelt wird, kann dieser in dem unterstellten Sonderfall der völligen Symmetrie direkt zur Anzeige gebracht werden. Tatsächlich ist jedoch bei einer praktisch stets vorhandenen Unsymmetrie der Ableitungsimpedanzen die Brückenbedingung nicht erfüllt, so daß am Meßwiderstand $R_M$ ein Netzspannungsanteil entsteht. Ein solcher würde unabhängig von der Verteilung der Netzableitungen an $R_M$ immer entstehen, falls nur eine einpolige Ankopplung der Auswerteschaltung A2 vorgenommen wird, also wenn R3 oder R4 unendlich groß wird. Bei geschlossenem Schalter S1 wird demnach der Auswerteschaltung A2 eine Schwebung im Sinne von Figur 3, Linker Teil, zugeführt, bei der der Meßspannungsanteil den Netzspannungsanteil und umgekehrt überlagern kann. Bei offenem Schalter S1 wird dagegen der Auswerteschaltung A2 lediglich der auch in der Schwebung vorhandene Netzspannungsanteil zugeleitet, was im rechten Teil von Figur 3 angedeutet ist.

Das Prinzip der Auswertung der Einrichtung aus Figur 6 beruht nun darauf, einerseits die maximale Spannungsamplitude der Schwebung bei geschlossenem Schalter S1 und andererseits die Spannungsamplitude des Netzsapnnungsanteils bei offenem Schalter S1 zu erfassen und die Differenz dieser Spannungsamplituden zu bilden. Dabei ergibt sich immer diejenige Spannungsamplitude, die bei eingeprägtem Meßwechselstrom proportional zur Gesamtableitungsimpedanz ist. Wenn in der Schwebung der Meßspannungsanteil den Netzsapnnungsanteil überlagert, ergibt die Differenzbildung die Spannungsamplitude der Schwebungshüllkurve. Wenn andererseits in der Schwebung der Netzsapnnungsanteil den Meßspannungsanteil überlagert, führt die Differenzbildung zu der zeitlich gemittelten Spannungsamplitude der Schwebung selbst. Demnach ist dieses Meßprinzip von einer Amplitudenbedingung unabhängig.

Die mit $C_K$ ausgekoppelte Schwebung wird in der Auswerteschaltung A2 aus Figur 6 einem Spitzenspannungsdetektor 40 zugeleitet. Dieser enthält eine mit dem Kondensator $C_K$ verbundene Gleichrichterdiode D und einen mit deren Ausgang sowie mit Erde 14 verbundenen Kondensator C1, dem ein gesteuerter Schalter S2 parallelgeschaltet ist. Der Kondensator C1 speichert vorübergehend den jeweiligen Spitzenwert der gleichgerichteten Spannung. Dieser Spitzenwert kann über einen hochohmigen Impedanzwandler N1 bei geshclossenem Schalter S3 einem speichernden Kondensator C3 oder bei geschlossenem Schalter S4 einem speichernden Kondensator C2 zugeführt werden. Diese Kondensatoren bilden einen Übernahmespeicher 42 zum Speichern verschiedener Spitzenwerte, deren Spannungsdifferenz mittels eines Differenzbildners 44 gebildet und in einem in Gesamtableitungsimpedanz geeichten Anzeigeinstrument 46 zur Anzeige gebracht werden kann.

Die Einrichtung aus Figur 6 arbeitet unter Bezugnahme auf Figur 8 wie folgt:

Es wird angenommen, daß der Meßzyklus zum Zeitpunkt $t_1$ beginnt. Zu diesem Zeitpunkt wird der Schalter S2 kurzfristig geschlossen, um den Kondensator C1 zu entladen. Gleichzeitig wird der Schalter S1 über wenigstens eine Periode der Schwebungshüllkurve, also der Differenzfrequenz zwischen $f_N$ und $f_M$, geschlossen, damit die maximale Spannungsamplitude der entstehenden Schwebung als erster Spitzenwert vorübergehend in C1 gespeichert werden kann. Zum Zeitpunkt $t_2$ bzw. wenigstens eine Zeitperiode nach dem Einschalten von S1 wird der Schalter S3 kurzfristig geschlossen, um den Spitzenwert aus C1 in C3 des Übernahmespeichers 42 zu übertragen. Zum Zeitpunkt $t_3$ werden der Schalter S1 geöffnet, um die Einspeisung des Meßwechselstroms zu unterbrechen, und der Schalter S2 kurzfristig geschlossen, damit C1 wieder entladen wird. Nachdem der Schalter S2 wieder geöffnet hat, wird die Spannungsamplitude des Netzspannungsanteils, also ohne Überlagerung, bzw. ein verminderter Wert desselben als zweiter Spitzenwert in C1 gespeichert. Zum Zeitpunkt $t_4$ wird der Schalter S4 kurzzeitig geschlossen, um diesen zweiten Spitzenwert in C2 des Übernahmespeichers 42 einzuspeichern. Es wird dann durch Differenzbildung der Spitzenwerte am Anzeigeinstrument 46 die

0 061 704

Gesamtableitungsimpedanz angezeigt. Ab dem Zeitpunkt $t_5$ folgt eine Wiederholung des taktenden Meßzyklus.

Das Zeitraster aus Figur 8 kann grundsätzlich verkürzt werden, da beispielsweise der Zeitpunkt $t_3$ für die Betätigung der Schalter S1 und S2 unmittelbar mit dem Öffnungszeitpunkt des Schalters S3 zusammenfallen kann. Außerdem kann die Zeit zwischen $t_3$ und $t_4$ verkürzt werden, da für die Erfassung der Spannungsamplutide des Netzspannungsanteils nur eine Periode der Netzfrequenz abgewartet werden muß. Und schließlich kann der Zeitpunkt $t_5$ mit dem Öffnungszeitpunkt des Schalters S4 zusammenfallen, also vorverlegt werden. Bei gleichmäßigem Zeitraster der in Figur 8 dargestellten Art ergibt sich ein Meßzyklus zwischen $t_1$ und $t_5$, der wenigstens der doppelten Periode der Schwebungshüllkurve entspricht.

Wenn die Einrichtung aus Figur 6 bei einem spannungslosen Wechselstromnetz angewendet wird oder wenn bei völlig symmetrisch verteilten Ableitungsimpedanzen der Netzsapannungsanteil und damit die Schwebung entfällt, wird dennoch der richtige Wert der Gesamtableitungsimpedanz zur Anzeige gebracht. Im ersten Teil des Meßzyklus, also bei geshclossenem Schalter S1, wird in C3 die Spannungsamplitude des Meßspannungsanteils bzw. ein entsprechend verminderter Wert gespeichert. Im zweiten Teil des Meßzyklus, also bei offenem Schalter S1, liegt überhaupt kein Spannungsanteil an, so daß im Kondensator C2 des Übernahmespeichers 42 der Spitzenwert « Null » gespeichert wird. Bei der Differenzbildung wird die der Gesamtableitungsimpedanz entsprechende Spannungsamplitude gebildet und zur Anzeige gebracht.

Die Ausführungsform aus Figur 9 ist im Zeusammenhang mit einem ungeerdeten Drehstromnetz mit drei Netzleitern 10, 11, 12 dargestellt, das von einer Drehstromquelle mit Netzfrequenz $f_N$ gespeist wird.

In Figur 9 ist in beispielhafter Weise dargestellt, daß die Meßfrequenz $f_M$ aus der Netzfrequenz $f_N$ abgeleitet werden kann, indem beispielsweise ein dynamischer Phasenschieber oder ein Frequenzvervielfacher 48 an das Netz angekoppelt wird und eine gegenüber der Netzfrequenz geringfügig verschobene Meßfrequenz erzeugt.

Beispsielsweise kann bei einer Netzfrequenz von 50 Hertz eine Meßfrequenz von 52 bis 53 Hertz abgeleitet werden, die sich entsprechend eventueller Schwankungen der Netzfrequenz ebenfalls so verändert, daß das Frequenz-Teilerverhältnis konstant bleibt. Stattdessen kann eine stets gleichbleibende dynamische Phasenverschiebung des Meßwechselstroms gegenüber dem Netz vorgesehen werden, so daß ein gleichbleibender Frequenzabstand zwischen der Netzfrequenz und der Meßfrequenz erhalten wird. Die hier lediglich beispielhaft angedeutete Ableitung der Meßfrequenz aus der Netzfrequenz kann auch bei den anderen Ausführungsformen eingesetzt werden.

Ein Verstärker 50 verstärkt das Meßfrequenz-Signal, das über einen Schalter 52 einem Transformator 54 zugeführt wird. Dieser sorgt für ein Hochtransformieren des Meßsignals auf eine Meßspannung $u_M$ von etwa 200 $V_{eff}$. Über ein Netzwerk von hochohmigen Ankoppelgliedern $R_{K1}$ sowie $R_{K2}$, die im vorliegenden Fall ohmsche Widerstände sind, wird ein Meßwechselstrom $i_M$ in das Drehstromnetz so eingeprägt, daß der Meßwechselstrom über die nicht dargestellten Netzableitungen nach Erde 14 abfließt, und zwar wie zuvor bei anstehender Netzspannung unter Bildung einer Schwebung an den Netzableitungen.

Durch an die Netzleiter 10, 11, 12 angeschlossene Ankoppelverstärker 56 werden die Leiterspannungen gegen Erde auf ein auswertbares Maß vermindert. Zwei der Ankoppelverstärker 56 werden benutzt, um wie bei der Ausführungsform aus Figur 5 mittels Gleichrichtung und Filterung die für die Gesamtableitungsimpedanz maßgebliche Meßspannungs- bzw. Schwebungshüllkurven-Amplitude oder ein hierzu proportionales Maß zu erhalten. Im vorliegenden Fall wird normalerweise nur die Leiterspannung des Netzleiters 11 über einen Schalter 58 einer entsprechenden Auswerteschaltung A3 zugeleitet. Ein Komparator 62 vergleicht die verminderten Leiterspannungen der Netzleiter 11, 12 in der bereits beschriebenen Weise untereinander oder ähnlich wie bei Figur 5 mit einer Vergleichsspannung. Immer dann, wenn der verminderte Netzspannungsanteil des Netzleiters 11 übermäßig absinkt, sorgt der Komparator 62 für ein Öffnen des Schalters 58 und für ein Schließen eines die verminderte Leiterspannung des Netzleiters 12 an die Auswerteschaltung A3 weiterleitenden Schalters 60. Es ist nicht erforderlich, eine diesbezügliche Umschaltung zwischen drei Netzleitern vorzusehen, was jedoch grundsätzlich möglich wäre.

Die Auswerteschaltung A3 besitzt eine Gleichrichter- und Filterschaltung 64, die dafür sorgt, daß aus der Schwebung ein Gleichspannungssignal $U_{EM}$ erzeugt wird, welches proportional zur Spannungsamplitude der Hüllkurve und somit der Gesamtableitungsimpedanz $Z_{E\,ges}$ ist, welche demnach direkt an einem in Gesamtableitungsimpedanz geeichten Anzeigeinstruments 66 angezeigt werden kann.

Die Gleichrichter- und Filterschaltung 64 kann in unterschiedlicher Weise aufgebaut werden und beispielsweise wie folgt arbeiten : Die anstehende Netzleiterspannung des Netzleiters 11 oder 12 wird gleichgerichtet und einem Tiefpaß zugeführt, an dessen Ausgang eine Gleichspannung mit der Überlagerung zur Verfügung steht. Ein Hochpaß läßt nur den Wechselspannungsanteil, also die Überlagerung selbst, passieren. Das anschließend verstärkte Signal gelangt zu einem aktiven Tiefpaß, der auf die Überlagerungs- bzw. Schwebungsfrequenz abgestimmt ist, so daß dahinter die sinusförmige und zur Gesamtableitungsimpedanz proportionale Überlagerungsspannung zur Verfügung steht. Anschließend sorgen ein Zweiweg-Gleichrichter und ein Tiefpaß für ein Erzeugen einer entsprechenden Gleichspannung. Da diese noch Wechselspannungsstöranteile enthalten kann, ist es möglich, diese in

11

einem Parallelzweig mit einem Hochpaß auszukoppeln und mit einer Phasendrehung von 180° wieder dem Hauptzweig zuzuführen. Durch die Gegenphasigkeit der Störanteile in den Haupt- und Parallelzweigen heben sich die Störanteile heraus. Die so erhaltene Gleichspannung kann dann weiterverarbeitet und/oder angezeigt werden.

Die zur Gesamtableitungsimpedanz proportionale Meßgleichspannung $U_{EM}$ wird bei der Ausführungsform aus Figur 9 gleichzeitig zum Bestimmen des maximal möglichen Leiterberührungsstromes in einer Sicherheitsschaltung S benutzt und zu diesem Zweck einem Analogdividierer 74 zugeleitet. Dieser sorgt dafür, daß ein ihm ebenfalls zugeführtes Gleichspannungssignal $U_{E\,max}$, das der maximalen Leiterspannung der Netzleiter 10, 11, 12 entspricht, durch die Z-proportionale Gleichspannung $U_{EM}$ geteilt wird. Dieser Quotient entspricht dem maximal möglichen Leiterberührungsstrom. Zum Erfassen der maximalen Leiterspannung sind drei aktive Gleichrichter 68 eingangsseitig mit den Ausgängen der Ankoppelverstärker 56 und ausgangsseitig in direkter Kopplung mit dem Eingang eines Tiefpasses 70 verbunden, dessen Ausgangssignal mit einem Verstärker 72 zu $U_{E\,max}$ verstärkt wird.

Das Ausgangssignal des Analogdividierers 74 wird in einem Verstärker 76 verstärkt und als maximal möglicher Leiterberührungsstrom $I_{E\,max}$ in einem Anzeigeinstrument zur Anzeige gebracht. Gleichzeitig ge langt das Ausgangssignal des Verstärkers 76 zu einem Schwellw ertschalter 80, der im Falle eines unzulässigen Anstei gens des maximal möglichen Leiterberührungsstromes im vorliegen den Fall einen warnenden Summer 84 und ein Relais 82 auslöst, welches beispielsweise für eine Netzabschaltung sorgen kann.

Wenn es erwünscht ist, kann zusät zlich in nicht dargestellter Weise mit Hilfe der Au sgangssignale der aktiven Gleichrichter 68 derjenige Netzleite r 10, 11, 12 angezeigt werden, zum Beispiel durch eine blinkende La mpe, der die maximale Leiterspannung führt und somit eine besondere Gefäh rdung darstellt.

Das Erfassen des maximal mögliche n Leiterberührungsstromes ist selbstverständlich auch bei den anderen Ausführungsformen mit ständiger oder taktender Meßwechselstrom-Einspeisung anwendbar.

Die dargestellten und beschriebenen Ausführungsformen sind beispielhaft und können bezüglich ihrer Detailausführung abgewandelt und den jeweiligen Erfordernissen angepaßt werden. Dies gilt beispielsweise für die Art der Netzankopplungen sowie -auskopplungen, für die Form des eingespeisten oder hochohmig eingeprägten Meßwechselstroms, für die Art der Erzeugung der Meßfrequenz bzw. der dynamischen Phasenverschiebung des Meßwechselstroms, für die Ausbildung der jeweils benutzten Auswerteschaltung, für die Verwendungsart des Meßergebnisses und dergleichen mehr. Wichtig ist dabei, daß die praktisch auf Netzfrequenz bezogene Gesamtableitungsimpedanz des Netzes bzw. der daraus herleitbare maximale Leiterberührungsstrom sehr genau und relativ einfach bestimmbar ist.

## Patentansprüche

1. Verfahren zum Bestimmen der Gesamtableitungsimpedanz in einem ungeerdeten Wechselstromnetz mittels eines in das Netz eingespeisten, insbesondere eingeprägten, über die Netzableitung fließenden Meßwechselstroms mit einer von der Frequenz der Netzwechselspannung abweichenden Frequenz und einer Auswertung der aus dem Meßwechselstrom resultierenden Meßwechselspannung zwischen Netz und Erde, dadurch gekennzeichnet, daß dem Wechselstromnetz ein Meßwechselstrom mit einer der Netzfrequenz angenäherten Meßfrequenz phasendynamisch so überlagert wird, daß sich bei anliegender Netzwechselspannung durch ständiges Verändern der relativen Phasenlage zwischen den einander überlagerten Netz- und Meßwechselspannungen eine Schwebung ergibt, und daß bei amplitudenkonstantem Meßwechselstrom als Maß für die Gesamtableitungsimpedanz bei anliegender Netzwechselspannung die Spannungsamplitude einer der die Schwebung beidseitig begrenzenden Schwebungshüllkurven, sofern der an der Meßstelle anstehende Anteil der Meßwechselspannung maximal gleich demjenigen der Netzwechselspannung ist, oder die sich aus den maximalen und minimalen Spannungsamplituden der Schwebung ergebende mittlere Spannungsamplitude der Schwebung, sofern der an der Meßstelle anstehende Anteil der Meßwechselspannung minimal gleich demjenigen der Netzwechselspannung ist, und bei an der Meßstelle verschwindendem Anteil der Netzwechselspannung bzw. wegfallender Schwebung die Spannungsamplitude der Meßwechselspannung erfaßt wird, während bei amplitudenvariablem Meßwechselstrom für die Gesamtableitungsimpedanz der Quotient der jeweiligen Spannungsamplitude und der gleichzeitig auftretenden Meßwechselstrom-Amplitude erfaßt wird.

2. Verfahren nach Anspruch 1, dadurch gekennzeichnet, daß ein Meßwechselstrom mit einer variablen Meßfrequenz überlagert wird, die abwechselnd geringfügig größer und geringfügig kleiner als die Netzfrequenz ist, und daß eine Mittelung der aus den sich dadurch ergebenden Schwebungen bestimmten Gesamtableitungsimpedanzen durchgeführt wird.

3. Verfahren nach Anspruch 2, dadurch gekennzeichnet, daß ein Meßwechselstrom mit einer variablen Meßfrequenz überlagert wird, deren negative Abweichung von der Netzfrequenz geringfügig kleiner als ihre positive Abweichung von der Netzfrequenz ist.

4. Verfahren nach Anspruch 2 oder 3, dadurch gekennzeichnet, daß ein um die Netzfrequenz herum frequenzmodulierter Meßwechselstrom überlagert wird.

5. Verfahren nach Anspruch 4, dadurch gekennzeichnet, daß die Meßfrequenz des Meßwechselstroms zeitlich linear verändert wird.

6. Verfahren nach Anspruch 1, dadurch gekennzeichnet, daß ein Wechselstrom von Netzfrequenz erzeugt, seine Phasenlage gegenüber dem Netz stetig verändert und dieser so modifizierte Wechselstrom als phasendynamischer Meßwsechselstrom dem Netz eingeprägt wird.

7. Verfahren nach einem oder mehreren der Ansprüche 1 bis 6, dadurch gekennzeichnet, daß die Frequenz des Meßwechselstroms durch Frequenzvervielfachung und/oder -teilung aus der Netzfrequenz abgeleitet wird.

8. Verfahren nach einem oder mehreren der Ansprüche 1 bis 7, dadurch gekennzeichnet, daß der Meßwechselstrom dem Netz mehrpolig symmetrisch eingeprägt wird.

9. Verfahren nach einem oder mehreren der Ansprüche 1 bis 8, dadurch gekennzeichnet, daß die Netzankopplung für die Auswertung mehrpolig symmetrisch durchgeführt wird.

10. Verfahren nach einem oder mehreren der Ansprüche 1 bis 8, dadurch gekennzeichnet, daß die Netzankopplung für die Auswertung einpolig durchgeführt wird.

11. Verfahren nach Anspruch 10, dadurch gekennzeichnet, daß der Netzspannungsanteil des jeweiligen Netzleiters erfaßt wird und daß die Netzankopplung immer dann auf einen anderen Netzleiter mit höherem Netzspannungsanteil umgeschaltet wird, wenn der erfaßte Netzspannungsanteil kleiner als der durch den Meßwechselstrom und die minimale Gesamtableitungsimpedanz bestimmte minimale Meßspannungsanteil wird.

12. Verfahren nach einem oder mehreren der Ansprüche 1 bis 11, dadurch gekennzeichnet, daß ein sinusförmiger Meßwechselstrom überlagert wird.

13. Verfahren nach einem oder mehreren der Ansprüche 1 bis 12, dadurch gekennzeichnet, daß der Meßwechselstrom getaktet wird, daß die sich bei aufgeprägtem Meßwechselstrom an der Meßstelle ergebende maximale Spannungsamplitude der Schwebung — bzw. bei verschwindender Netzwechselspannung der Meßwechselspannung — erfaßt wird, daß die sich bei unterbrochenem Meßwechselstrom an der Meßstelle ergebende Spannungsamplitude der Netzwechselspannung erfaßt wird und daß als Maß für die Gesamtableitungsimpedanz die Differenz dieser Spannungsamplituden gebildet wird.

14. Verfahren nach einem oder mehreren der Ansprüche 1 bis 12, dadurch gekennzeichnet, daß der Meßwechselstrom dem Netz ständig überlagert wird, daß die Spannungsmaxima sowie -minima der Schwebungshüllkurve nach dem Samplingprinzip erfaßt wird und daß die Differenz dieser Spannungswerte gebildet wird.

15. Verfahren nach einem oder mehreren der Ansprüche 1 bis 12, dadurch gekennzeichnet, daß der Meßwechselstrom dem Netz ständig überlagert wird, daß die Schwebungsfrequenz ausgefiltert wird und daß die Spannungsamplitude der Hüllkurve bestimmt wird.

16. Verfahren nach einem oder mehreren der Ansprüche 1 bis 15, dadurch gekennzeichnet, daß die auf der Netzwechselspannung beruhende Maximalspannung der Netzleiter gegen Erde bestimmt sowie durch das der Gesamtableitungsimpedanz entsprechende Maß geteilt wird und daß der sich hierbei ergebende maximal mögliche Berührungsfehlerstrom zur Anzeige und/oder Auslösung gebracht wird.

17. Einrichtung zum Durchführen des Verfahrens nach einem oder mehreren der Ansprüche 1 bis 16 mit einer geerdeten sowie zumindest einpolig an das Wechselstromnetz angekoppelten Meßwechselstrom-Quelle mit einer von der Frequenz der Netzwechselspannung abweichenden Frequenz und mit einer geerdeten sowie zumindest einpolig an das Wechselstromnetz angekoppelten Auswerteschaltung, die die aus dem über die Netzableitung fließenden Meßwechselstrom resultierende Meßwechselspannung zwischen Netz und Erde als Maß für die Gesamtableitungsimpedanz erfaßt, gekennzeichnet durch eine gegenüber dem Wechselstromnetz phasendynamische Meßwechselstrom-Quelle (18 ; 48-54), deren Meßwechselstrom bei annähernd Netzfrequenz eine sich in bezug auf das Wechselstromnetz ständig verändernde, bei anliegender Netzwechselspannung am Wechselstromnetz zu einer Schwebung führende Phasenlage hat, und durch eine Auswerteschaltung (A1, A2, A3) zum Bestimmen des auf dem Meßwechselstrom beruhenden Meßwechselspannungsanteils der Schwebung.

18. Einrichtung nach Anspruch 17, gekennzeichnet durch eine der Anzahl der Netzleiter (10, 12 ; 10, 11, 12) entsprechend mehrpolige, gegenüber der Gesamtableitungsimpedanz ($Z_E$) hochohmige, symmetrische Netzankopplung ($R_1$, $R_2$ ; $R_{K1}$) der Meßwechselstrom-Quelle (18 ; 48-54).

19. Einrichtung nach Anspruch 17 oder 18, gekennzeichnet durch eine über einen Schalter ($S_1$ ; 52) mit dem Netz verbindbare Meßwechselstrom-Quelle (18 ; 48-54).

20. Einrichtung nach einem oder mehreren der Ansprüche 17 bis 19, gekennzeichnet durch eine Meßwechselstrom-Quelle (18 ; 48-54) mit sinusförmigem Meßwechselstrom.

21. Einrichtung nach einem oder mehreren der Ansprüche 17 bis 20, gekennzeichnet durch eine Meßwechselstrom-Quelle (18 ; 48-54) mit einer in bezug auf die Netzfrequenz zwischen positiven und negativen Frequenzabweichungen umschaltenden oder modulierten Meßfrequenz.

22. Einrichtung nach einem oder mehreren der Ansprüche 17 bis 21, gekennzeichnet durch eine Meßwechselstrom-Quelle (48) mit einem an die Netzfrequenz gekoppelten und hieraus die Meßfrequenz durch Frequenzvervielfachung und/oder -teilung bildenden Meßfrequenz-Erzeuger (48).

23. Einrichtung nach einem oder mehreren der Ansprüche 17 bis 21, gekennzeichnet durch einen an das Wechselstromnetz gekoppelten dynamischen Phasenschieber zum Erzeugen eines gegenüber dem Wechselstromnetz phasendynamischen Meßwechselstroms.

24. Einrichtung nach einem oder mehreren der Ansprüche 17 bis 23, gekennzeichnet durch eine gegenüber der Gesamtableitungsimpedanz hochohmige, spannungsvermindernde und nur Wechsel-

13

spannungsanteile durchlassende Netzankopplung ($C_{K1}$, $C_{K2}$, 20, 22 ; $R_3$, $R_4$, $R_M$, $C_K$ ; 56) der Auswerteschaltung (A1, A2, A3).

25. Einrichtung nach Anspruch 24, gekennzeichnet durch einen Spannungsvergleicher (28 ; 62) und durch einen hiervon betätigten Schalter (30 ; 58, 60), der die jeweils einpolige Netzankopplung (20, 22 ; 56) immer dann von einem Netzleiter auf einen anderen Netzleiter umschaltet, wenn die Netzwechselspannung des einen Netzleiters kleiner als eine bestimmte Vergleichsspannung oder kleiner als die Netzwechselspannung des anderen Netzleiters wird.

26. Einrichtung nach Anspruch 24, gekennzeichnet durch eine der Anzahl der Netzleiter (10, 12 ; 10, 11, 12) entsprechend mehrpolige, symmetrische Netzankopplung ($R_3$, $R_4$, $R_M$, $C_K$).

27. Einrichtung nach Anspruch 26, gekennzeichnet durch mit den einzelnen Netzableitungen ($Z_{E1}$, $Z_{E2}$) eine Meßbrücke bildende ohmsche Ankopplungswiderstände ($R_3$, $R_4$) und durch einen im Brückennullzweig liegenden, an die Auswerteschaltung (A2) kapazitiv angekoppelten ohmschen Meßwiderstand ($R_M$).

28. Einrichtung nach einem oder mehreren der Ansprüche 17 bis 27, gekennzeichnet durch eine den Meßwechselstrom während des Meßvorgangs ständig einspeisende Meßwechselstrom-Quelle und durch eine durch Gleichrichten und Filtern die Schwebungsfrequenz ausfilternde sowie die Spannungsamplitude der Schwebungshüllkurve bestimmende Auswerteschaltung (A1, A3).

29. Einrichtung nach einem oder mehreren der Ansprüche 17 bis 27, gekennzeichnet durch eine den Meßwechselstrom während des Meßvorgangs ständig einspeisende Meßwechselstrom-Quelle und durch eine die Spannungsmaxima sowie -minima der Schwebungshüllkurve nach dem Samplingprinzip erfassende und deren Differenz bildende Auswerteschaltung.

30. Einrichtung nach einem oder mehreren der Ansprüche 17 bis 27, gekennzeichnet durch eine den Meßwechselstrom taktend einspeisende Meßwechselstrom-Quelle und durch eine Auswerteschaltung (A2) mit einem Spitzenspannungsdetektor (40) zum Erfassen der an der Meßstelle jeweils mit und ohne Meßwechselstrom-Einspeisung auftretenden Spannungsmaxima, durch zwei an den Spitzenspannungsdetektor abwechselnd anschließbare Übernahmespeicher (42) zum vorübergehenden Speichern der Spannungsmaxima und durch einen Differenzbildner zum Bestimmen der Differenz der gespeicherten Maxima.

31. Einrichtung nach einem oder mehreren der Ansprüche 17 bis 30, gekennzeichnet durch eine Sicherheitsschaltung (S) mit einem Maximalspannung-Detektor (68, 70, 72) zum Bestimmen der maximalen Leiterspannung des Wechselstromnetzes gegenüber Erde und durch einen Analogdividierer (74) zum Dividieren dieser maximalen leiterspannung durch die von der Auswerteschaltung (A1, A2, A3) bestimmte Gesamtableitungsimpedanz.

32. Einrichtung nach einem oder mehreren der Ansprüche 17 bis 31, gekennzeichnet durch Anzeige- und/oder Warn- und/oder Auslösemittel (38 ; 46 ; 66, 78, 82, 84) für die Gesamtableitungsimpedanz und/oder den maximalen Leiterberührungsstrom.

33. Einrichtung nach einem oder mehreren der Ansprüche 17 bis 32, gekennzeichnet durch eine Meßwechselstrom-Quelle (18 ; 48-54) mit einer von der Netzfrequenz um bis etwa zehn Prozent abweichenden Meßfrequenz.

**Claims**

1. A method for determining the total leakage impedance in an ungrounded AC power supply system by means of an AC measurement current having a frequency differing from the frequency of the AC system voltage is fed into, and more specifically injected into the system and passing through the system leakage, and by means of evaluation of the AC measurement voltage between system and ground resulting from the AC measurement current, characterized in that an AC measurement current having a measurement frequency near the power supply system frequency is phase-dynamically superimposed on the AC power supply system in such a way that, in the case in which an AC system voltage is present, an interference pattern will result from the continuous changing of the relative phase position between the system voltage and the AC measurement voltage, which voltages are superimposed one on the other, and that, in the case of a constant amplitude AC measurement current as an indicator of the total leakage impedance, when the AC system voltage is present, the voltage amplitude of one of the interference pattern envelopes, which bound the interference pattern on both sides, is detected and indicated if the component of the AC measurement voltage at the point of measuring is no greater than the component of the AC system voltage at this point, or the mean voltage amplitude of the interference pattern is detected and indicated if the component of AC measurement voltage at the point of measuring is no less than the component of AC system voltage at this point, the voltage amplitude of the AC measurement voltage component will be detected and indicated if at the point of measuring, the component of AC system voltage disappears, i. e. the interference pattern does not exist, while in the case of an AC measurement current of varying amplitude, the quotient of the respective voltage amplitude and of the simultaneously occurring amplitude of the AC measurement current is detected and used to indicate the total leakage impedance.

2. A method according to claim 1, characterized in that an AC measurement current is superimposed using a variable measurement frequency which is alternately slightly larger and slightly lower than the

**0 061 704**

system frequency and that the mean value of the total leakage impedances is detected, determined by the resulting interference patterns.

3. A method according to claim 2, characterized in that an AC measurement current is superimposed using a variable measurement frequency whose negative deviation from the system frequency is slightly smaller than its positive deviation from the system frequency.

4. A method according to claim 2 or 3, characterized in that an AC measurement current is superimposed whose frequency is modulated about the system frequency.

5. A method according to claim 4, characterized in that the measurement frequency of the AC measurement current is varied linearly with time.

6. A method according to claim 1, characterized in that an AC current is produced the frequency of which equals the system frequency and the phase of which is then continuously dynamically changed with respect to the phase of the power supply system and that this modified AC current is impressed into said power supply system as a phase-dynamical AC measurement current.

7. A method according to one or several of claims 1 to 6, characterized in that the frequency of the AC measurement current is derived from the system frequency by multiplication and/or division.

8. A method according to one or several of claims 1 to 7, characterized in that the AC measurement current is injected into the power supply system symmetrically and with multiple poling.

9. A method according to one or several of claims 1 to 8, characterized in that the connecting to said power supply system for the evaluation is symmetrical and through multiple poling.

10. A method according to one or several of claims 1 to 8, characterized in that the connecting to said power supply system for said evaluation is carried out using only one pole.

11. A method according to claim 10, characterized in that the system voltage component is detected for each individual system conductor and that the system connection is switched over to another system conductor with a larger component of the system voltage whenever the detected system voltage component is smaller than the minimum measurement voltage component as determined by the AC measurement current and the minimum total leakage impedance.

12. A method according to one or several of claims 1 to 11, characterized in that a sinusoidal AC measurement current is superimposed.

13. A method according to one or several of claims 1 to 12, characterized in that the AC measurement current is periodically injected, that the maximum voltage amplitude of the interference pattern or, when the AC system voltage disappears, of the AC measurement voltage, is detected at the measurement point when said measurement current is being impressed, that the amplitude of the AC system voltage is detected at said measuring point when said AC measurement current is interrupted, and that the difference between these voltage amplitudes is calculated as an indicator of the total leakage impedance.

14. A method according to one or several of claims 1 to 12, characterized in that the AC measurement current is continuously superimposed on the power supply system, that the maximum and minimum voltages of the envelope bounding the interference pattern are detected according to the principle of sampling and that the difference between these voltage extremes is determined.

15. A method according to one or several of claims 1 to 12, characterized in that the AC measurement current is continuously superimposed on the power supply system, that the interference frequency is filtered out, and that the voltage amplitude of the interference pattern envelope is determined.

16. A method according to one or several of claims 1 to 15, characterized in that the largest voltage present on the system conductors with respect to ground due to the AC power supply system voltage is determined and divided by a quantity representing the total leakage impedance and that the resulting maximum possible contact fault current is indicated and/or an alarm is actuated.

17. An apparatus for carrying out the method according to one or several of claims 1 to 16, comprising a grounded AC measurement current source having a frequency differing from the frequency of the AC system voltage and beeing connected to the AC power supply system by at least one pole, and a grounded evaluation circuit which is connected to the AC power supply system by at least one pole, which detects the AC measurement voltage between system and ground resulting from the AC measurement current passing through the system leakage as an indicator of the total leakage impedance, characterized by an AC measurement current source (18 ; 48-54) with a varying phase with respect to the AC power supply system, whose frequency approaches the system frequency and has a phase which changes continuously with respect to the power supply system, thus causing an interference pattern if an AC system voltage has built up in the AC power supply system, and by an evaluation circuit (A1, A2, A3) for the determination of the AC measurement voltage component of the interference pattern resulting from the AC measurement current.

18. An apparatus according to claim 17, characterized by a system connection ($R_1$, $R_2$, $R_{K1}$) of the AC measurement current source (18 ; 48-54), having multiple poling in accordance with the number of system conductors (10, 12 ; 10, 11, 12) and high impedance compared with the total leakage impedance ($Z_E$), and which is symmetrical.

19. An apparatus according to claim 17 or 18, characterized by an AC measurement current source (18 ; 48-54) which can be connected to the power supply system by a switch ($S_1$ ; 52).

20. An apparatus according to one or several of claims 17 to 19, characterized by an AC measurement current source (18 ; 48-54) with sinusoidal AC measurement current.

15

21. An apparatus according to one or several of claims 17 to 20, characterized by an AC measurement current source (18 ; 48-54) having a measurement frequency which is modulated or alternated between positive and negative deviations with respect to the system frequency.

22. An apparatus according to one or several of claims 17 to 21, characterized by an AC measurement current source (48) with a measurement frequency generator (48) coupled to the system frequency so as to generate the measurement frequency by multiplication and/or division of frequencies.

23. An apparatus according to one or several of claims 17 to 21, characterized by a dynamic phase shifter coupled to the AC power supply system to generate an AC measurement current having a varying phase with respect to the AC power supply system.

24. An apparatus according to one or several of claims 17 to 23, characterized by a system connection ($C_{K1}$, $C_{K2}$, 20, 22 ; $R_3$, $R_4$, $R_M$, $C_K$ ; 56) for the evaluation circuit (A1, A2, A2) which is of high impedance or resistance compared to the total leakage impedance, which reduces the voltage values and which transmits only the AC voltage components.

25. An apparatus according to claim 24, characterized by a voltage comparator (28 ; 62) and by a switch (30 ; 58, 60) actuated thereby which switches the one-pole system connection (20, 22 ; 56) from one system conductor to another whenever the AC system voltage on said one system conductor is smaller than a certain reference voltage or smaller than the AC system voltage on said other conductor.

26. An apparatus according to claim 24, characterized by a system connection ($R_3$, $R_4$, $R_M$, $C_K$) which is symmetrical and has as many poles as there are system conductors (10, 12 ; 10, 11, 12).

27. An apparatus according to claim 26, characterized by resistive coupling impedances ($R_3$, $R_4$) which form a measuring bridge with the individual leakage impedances ($Z_{E1}$, $Z_{E2}$) and by a resistive measurement impedance ($R_M$) which is located in the null arm of the bridge and is capacitively connected to the evaluation circuit (A2).

28. An apparatus according to one or several of claims 17 to 27, characterized by an AC measurement current source which injects the measurement current continuously during the measuring process and by an Ac measurement current source which injects the measurement current continuously during the measuring process and by evaluation circuit (A1, A3) which filters out the difference or beat frequency by rectification and filtering and which determines the voltage amplitude of the envelope bounding the interference pattern.

29. An apparatus according to one or several of claims 17 to 27, characterized by an AC measurement current source which injects the measurement current continuously during the measuring process and by an evaluation circuit which detects the voltage maxima and minima of the envelope bounding the interference pattern by using the sampling principle, and calculates their difference.

30. An apparatus according to one or several of claims 17 to 27, characterized by an AC measurement current source which injects the measurement current periodically, and by an evaluation circuit (A2) with a peak voltage detector (40) for detecting maximum voltage values at the measurement point with and without the AC measurement current injection, by two storage devices (42) which can be alternately connected to the peak voltage detector for the temporary storage of the voltage maxima, and by a difference detector for the determination of the differences between the stored voltage maxima.

31. An apparatus according to one or several of claims 17 to 30, characterized by a safety circuit (S) comprising a peak voltage detector (68, 70, 72) for determining the maximum conductor voltage of the AC power supply system with respect to the ground, and by an analog divider (74) for dividing said maximum conductor voltage by the total leakage impedance as determined by the evaluation circuit (A1, A2, A3).

32. An apparatus according to one or several of claims 17 to 31, characterized by indicator and/or warning and/or triggering means (38 ; 46 ; 66, 78, 82, 84) for the total leakage impedance and/or the maximum conductor contact current.

33. An apparatus according to one or several of claims 17 to 32, characterized by an AC measurement current source (18 ; 48-54) with a measurement frequency which differs from the system frequency by only up to about 10 %.

## Revendications

1. Procédé pour déterminer l'impédance de fuite totale dans un réseau à courant alternatif non mis à la terre, au moyen d'un courant alternatif de mesure fourni au réseau, en particulier injecté dans celui-ci, circulant par la fuite du réseau et ayant une fréquence différente de la fréquence de la tension alternative du réseau et au moyen d'une évaluation de la tension alternative de mesure résultant du courant alternatif de mesure entre le réseau et la terre, caractérisé en ce qu'on surajoute au réseau alternatif, en dynamique de phase, un courant alternatif de mesure ayant une fréquence de mesure s'approchant de la fréquence du réseau de sorte que, pour une tension alternative de réseau donnée, il se produit un battement par variation constante de la relation de phase entre les tensions alternatives de réseau et de mesure, surajoutées l'une à l'autre, et en ce que, pour un courant alternatif de mesure d'amplitude constante, la mesure de l'impédance de fuite totale pour la tension alternative du réseau donnée est obtenue par l'amplitude de tension de l'une des courbes enveloppes de battement limitant le battement de chaque côte, pour autant que la portion de la tension alternative de mesure apparaissant sur le site de mesure soit au maximum égale à celle de la tension alternative du réseau, ou bien par l'amplitude de tension moyenne

**0 061 704**

du battement qui provient des amplitudes de tension maximales et minimales du battement, pour autant que la portion de la tension alternative de mesure apparaissant sur le site de mesure soit au minimum égale à celle de la tension alternative du réseau, ou bien, lorsque la portion de la tension alternative du réseau disparaît sur le site de mesure ou pour la chute du battement, ladite mesure est obtenue par l'amplitude de tension de la tension alternative de mesure, alors que, pour un courant alternatif de mesure d'amplitude variable, l'impédance de fuite totale est déterminée par le quotient de l'amplitude de tension et de l'amplitude du courant alternatif de mesure se produisant simultanément.

2. Procédé selon la revendication 1, caractérisé en ce qu'on surajoute un courant alternatif de mesure ayant une fréquence de mesure variable qui est alternativement légèrement supérieure et légèrement inférieure à la fréquence du réseau, et que l'on réalise une opération de moyenne des impédances de fuite totale déterminées à partir des battements ainsi obtenus.

3. Procédé selon la revendication 2, caractérisé en ce qu'on surajoute un courant alternatif de mesure ayant une fréquence de mesure variable, dont l'excursion négative par rapport à la fréquence du réseau est légèrement plus faible que son excursion positive par rapport à la fréquence du réseau.

4. Procédé selon la revendication 2 ou la revendication 3, caractérisé en ce qu'on surajoute un courant alternatif de mesure modulé en fréquence autour de la fréquence du réseau.

5. Procédé selon la revendication 4, caractérisé en ce que la fréquence de mesure du courant alternatif de mesure varie linéairement dans le temps.

6. Procédé selon la revendication 1, caractérisé en ce qu'on produit un courant alternatif de la fréquence du réseau, on fait varier régulièrement sa relation de phase par rapport au réseau et on applique ce courant alternatif ainsi modifié en tant que courant alternatif de mesure en dynamique de phase au réseau.

7. Procédé selon l'une ou plusieurs des revendications 1 à 6, caractérisé en ce que la fréquence du courant alternatif de mesure dérive de la fréquence du réseau par multiplication de fréquence et/ou division de fréquence.

8. Procédé selon l'une ou plusieurs des revendications 1 à 7, caractérisé en ce que le courant alternatif de mesure est appliqué au réseau sous forme multipolaire symétrique.

9. Procédé selon l'une ou plusieurs des revendications 1 à 8, caractérisé en ce que le couplage au réseau pour l'évaluation est réalisé sous forme multipolaire symétrique.

10. Procédé selon l'une ou plusieurs des revendications 1 à 8, caractérisé en ce que le couplage au réseau pour l'évaluation est réalisé sous forme unipolaire.

11. Procédé selon la revendication 10, caractérisé en ce qu'on détecte la portion de tension de réseau des conducteurs respectifs du réseau et en ce que le couplage du réseau est alors toujours commuté sur un autre conducteur du réseau ayant une portion de tension de réseau plus élevée, lorsque la portion de tension de réseau détectée devient plus faible que celle détectée par le courant alternatif de mesure et que l'impédance de dérivation totale minimale devient plus faible qu'une portion de tension de mesure minimale déterminée.

12. Procédé selon l'une ou plusieurs des revendications 1 à 11, caractérisé en ce qu'on surajoute un courant alternatif de mesure de forme sinusoïdale.

13. Procédé selon l'une ou plusieurs des revendications 1 à 12, caractérisé en ce qu'on pulse le courant alternatif de mesure, on détecte l'amplitude de tension maximale du battement se produisant pour le courant alternatif de mesure appliqué au site de mesure ou de la tension alternative de mesure pour la tension alternative de réseau qui disparaît, on détecte l'amplitude de tension de la tension alternative du réseau obtenue pour le courant alternatif de mesure interrompu sur le site de mesure et on forme la différence de ces amplitudes de tension comme mesure de l'impédance de fuite totale.

14. Procédé selon l'une ou plusieurs des revendications 1 à 12, caractérisé en ce qu'on surajoute constamment le courant alternatif de mesure au réseau, on détecte les maxima et minima de tension des courbes enveloppes de battement selon le principe d'échantillonnage et on forme la différence de ces valeurs de tension.

15. Procédé selon l'une ou plusieurs des revendications 1 à 12, caractérisé en ce qu'on surajoute constamment le courant alternatif de mesure au réseau, on filtre la fréquence de battement et on détermine l'amplitude de tension des courbes enveloppes.

16. Procédé selon l'une ou plusieurs des revendications 1 à 15, caractérisé en ce qu'on détermine par rapport à la terre la tension maximale des conducteurs du réseau, s'établissant pour la tension alternative du réseau, on divise cette tension maximale par la mesure correspondante de l'impédance de fuite totale et on utilise le courant de défaut maximal possible pour la signalisation et/ou le déclenchement.

17. Dispositif pour la mise en œuvre du procédé selon l'une ou plusieurs des revendications 1 à 16, comportant une source de courant alternatif de mesure non mise à la terre et couplée au moins unipolairement au réseau de courant alternatif, et ayant une fréquence différente de la fréquence de la tension alternative du réseau, et comportant un montage d'évaluation non mis à la terre et couplé au moins unipolairement au réseau de courant alternatif, lequel montage détecte la tension alternative de mesure, qui résulte du courant alternatif de mesure circulant par les conducteurs du réseau, entre le réseau et la terre en tant que mesure de l'impédance de fuite totale, caractérisé en ce qu'il comprend une source de courant alternatif de mesure (18 ; 48-54) en dynamique de phase par rapport au réseau de

17

courant alternatif, dont le courant alternatif de mesure, pour une fréquence s'approchant de celle du réseau, possède une relation de phase variant constamment par rapport au réseau alternatif de mesure et conduisant à un battement pour la tension alternative du réseau correspondante appliquée au réseau de courant alternatif, et en ce qu'il comprend un montage d'évaluation (A1, A2, A3) pour déterminer la portion de la tension alternative de mesure du battement, qui provient du courant alternatif de mesure.

18. Dispositif selon la revendication 17, caractérisé par un couplage de réseau ($R_1$, $R_2$ ; $R_{K1}$) de la source de courant alternatif de mesure (18 ; 48-54), ce couplage étant multipolaire en correspondance du nombre des conducteurs du réseau (10, 12 ; 10, 11, 12) de valeur ohmique élevée par rapport à l'impédance de fuite totale ($Z_E$), et symétrique.

19. Dispositif selon la revendication 17 ou la revendication 18, caractérisé par une source de courant alternatif de mesure (18 ; 48-54) pouvant être reliée au réseau par un commutateur ($S_1$ ; 52).

20. Dispositif selon l'une ou plusieurs des revendications 17 à 19, caractérisé par une source de courant alternatif de mesure (18 ; 48-54) ayant un courant alternatif de mesure de forme sinusoïdale.

21. Dispositif selon l'une ou plusieurs des revendications 17 à 20, caractérisé par une source de courant alternatif de mesure (18 ; 48-54) ayant une fréquence de mesure commutable ou modulée entre des excursions positives et négatives de fréquence par rapport à la fréquence du réseau.

22. Dispositif selon l'une ou plusieurs des revendications 17 à 21, caractérisé par une source de courant alternatif de mesure (48) comprenant un générateur (48) de fréquence de mesure couplé à la fréquence du réseau et formant ainsi la fréquence de mesure par multiplication et/ou division de fréquence.

23. Dispositif selon l'une ou plusieurs des revendications 17 à 21, caractérisé par un déphaseur dynamique couplé au réseau de courant alternatif pour produire un courant alternatif de mesure en phase dynamique par rapport au réseau de courant alternatif.

24. Dispositif selon l'une ou plusieurs des revendications 17 à 23, caractérisé par un couplage de réseau ($C_{K1}$, $C_{K2}$, 20, 22 ; $R_3$, $R_4$, $R_M$, $C_K$ ; 56) du montage d'évaluation (A1, A2, A3), de valeur ohmique élevée par rapport à l'impédance de fuite totale, abaissant la tension et laissant passer seulement des portions de la tension alternative.

25. Dispositif selon la revendication 24, caractérisé par un comparateur de tension (28 ; 62) et par un commutateur (30 ; 58, 60) actionné par celui-ci, qui commute alors toujours le couplage de réseau unipolaire (20, 22 ; 56) d'un conducteur du réseau à un autre conducteur du réseau, lorsque la tension alternative de réseau de l'un des conducteurs du réseau devient plus faible qu'une tension de comparaison déterminée ou plus faible que la tension alternative de réseau de l'autre conducteur de réseau.

26. Dispositif selon la revendication 24, caractérisé par un couplage de réseau ($R_3$, $R_4$, $R_M$, $C_K$) symétrique et multipolaire en correspondance du nombre des conducteurs du réseau (10, 12 ; 10, 11, 12).

27. Dispositif selon la revendication 26, caractérisé par des résistances ohmiques de couplage ($R_3$, $R_4$) formant un pont de mesure avec les conducteurs individuels du réseau ($Z_{E1}$, $Z_{E2}$) et par une résistance ohmique de mesure ($R_M$) se trouvant dans la branche nulle du pont et couplée de façon capacitive au montage d'évaluation (A2).

28. Dispositif selon l'une ou plusieurs des revendications 17 à 27, caractérisé par une source de courant alternatif de mesure fournissant constamment le courant alternatif de mesure pendant l'opération de mesure et par un montage d'évaluation (A1, A3) filtrant la fréquence de battement par des égalisateurs et des filtres et déterminant l'amplitude de tension des courbes enveloppes du battement.

29. Dispositif selon l'une ou plusieurs des revendications 17 à 27, caractérisé par une source de courant alternatif de mesure fournissant constamment le courant alternatif de mesure pendant l'opération de mesure et par un montage d'évaluation enregistrant les maxima et minima des courbes enveloppes du battement selon le principe d'échantillonnage et formant leur différence.

30. Dispositif selon l'une ou plusieurs des revendications 17 à 27, caractérisé par une source de courant alternatif de mesure fournissant par impulsions le courant alternatif de mesure et par un montage d'évaluation (A2) ayant un détecteur de tension de pointe (40) pour enregistrer les maxima de tension se produisant à chaque fois sur le site de mesure avec ou sans alimentation en courant alternatif de mesure, deux mémoires de transfert (42) pouvant être raccordées alternativement au détecteur de tension de pointe pour mémoriser temporairement les maxima de tension et déterminer au moyen d'un organe différentiel la différence des maxima stockés en mémoire.

31. Dispositif selon l'une ou plusieurs des revendications 17 à 30, caractérisé par un montage de sécurité (S) comportant un détecteur de tension maximale (68, 70, 72) pour déterminer la tension de conducteur maximale du réseau de courant alternatif par rapport à la terre et par un diviseur analogique (74) pour diviser cette tension de conducteur maximale par l'impédance de fuite totale déterminée par le montage d'évaluation (A1, A2, A3).

32. Dispositif selon l'une ou plusieurs des revendications 17 à 31, caractérisé par des organes de signalisation et/ou d'avertissement et/ou de déclenchement (38 ; 46 ; 66, 78, 82, 84) pour l'impédance de fuite totale et/ou le courant admissible maximal des conducteurs.

33. Dispositif selon l'une ou plusieurs des revendications 17 à 32, caractérisé par une source de courant alternatif de mesure (18 ; 48-54) dont la fréquence de mesure s'écarte jusqu'à environ 10 % par rapport à la fréquence du réseau.

0 061 704

*Fig.1*

*Fig.2*

_Fig. 3_

_Fig.4_

_Fig. 5_

_Fig.6_

_Fig.7_

_Fig.8_

3

_Fig.9_